# EUROPEAN PATENT APPLICATION

(11) **EP 4 439 621 A1**
(43) Date of publication of application: **02.10.2024**
(21) Application number: 23165343.7
(22) Date of filing: 30.03.2023
(51) Int. Cl.: H01J 37/02, H01J 37/09

(54) **SHIELD ARRANGEMENT FOR ELECTRON-OPTICAL MODULE**

(71) Applicant: ASML Netherlands B.V., 5500 AH Veldhoven (NL)
(72) Inventor: KONING, Johan, Joost, 5500 AH Veldhoven (NL)
(74) Representative: ASML Netherlands B.V.

(57) **Abstract**

A charged particle-optical module for a charged particle-optical device configured to direct a charged particle beam along a beam path towards a sample location, the charged particle-optical module comprising: a stack comprising charged particle-optical plates arranged across the beam path and configured to operate on the charged particle beam; and a shield arrangement comprising an upbeam electrostatic shield arranged across the beam path upbeam of the charged particle-optical plates; and a downbeam electrostatic shield arranged across the beam path downbeam of the charged particle-optical plates, wherein the shield arrangement is configured to deter electrical breakdown between the charged particle-optical module and a component external to the charged particle-optical module and/or to confine an electrostatic field within the charged particle-optical module, the electrostatic field for example generated in operation of the charged particle-optical plates on the charged particle beam along the beam path.

## Description

### FIELD

The embodiments provided herein generally relate to a charged particle-optical module, a charged particle-optical device, a charged particle-optical apparatus and a method of directing a charged particle beam.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incidental particles or other processing step such as etching, deposition of chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern assessment systems for example pattern inspection tools with a charged particle beam have been used to assess objects, for example to detect pattern defects. These tools typically use electron microscopy techniques, such as a scanning electron microscope (SEM). In a SEM, a primary electron beam of electrons at a relatively high energy is targeted with a final deceleration step in order to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons, which together may be referred as signal electrons or more generally signal particles. The generated secondary electrons may be emitted from the material structure of the target.

By scanning the primary electron beam as the probing spot over the target surface, secondary electrons can be emitted across the surface of the target. By collecting these emitted secondary electrons from the target surface, a pattern inspection tool (or apparatus) may obtain an image-like signal representing characteristics of the material structure of the surface of the target. In such inspection the collected secondary electrons are detected by a detector within the apparatus. The detector generates a signal in response to the incidental particle. As an area of the sample is inspected, the signals comprise data which is processed to generate the inspection image corresponding to the inspected area of the sample. The image may comprise pixels. Each pixel may correspond to a portion of the inspected area. Typically electron beam inspection apparatus has a single beam and may be referred to as a Single Beam SEM. There have been attempts to introduce a multi-electron beam inspection in an apparatus (or a `multi-beam tool') which may be referred to as Multi Beam SEM (MBSEM).

Another application for an electron-optical device (or column) is lithography. The charged particle beam reacts with a resist layer on the surface of a substrate. A desired pattern in the resist can be created by controlling the locations on the resist layer that the charged particle beam is directed towards.

An electron-optical device may be an apparatus for generating, illuminating, projecting and/or detecting one or more beams of charged particles. The path of the beam of charged particles is controlled by electromagnetic fields (i.e. electrostatic fields and optionally magnetic fields).

Electrical signals (e.g. power and/or communication) may be transferred to and/or from electronic components of the electron-optical device, for example to operate on the beams of charged particles and/or process signals of collected electrons. There is a risk of undesirable electrical discharge between an electrical cable, an electrical connector or an electron-optical component of the electron-optical device and another component.

### SUMMARY

The present invention provides a suitable architecture to mitigate the risk of electrical discharge.

According to a first aspect of the invention, there is provided a charged particle-optical module for a charged particle-optical device configured to direct a charged particle beam along a beam path towards a sample location, the charged particle-optical module comprising:
a stack comprising one or more charged particle-optical plates arranged across the beam path and configured to operate on the charged particle beam; and
a shield arrangement comprising an upbeam electrostatic shield arranged across the beam path upbeam of the one or more charged particle-optical plates; and a downbeam electrostatic shield arranged across the beam path downbeam of the one or more charged particle-optical plates,
wherein the shield arrangement is configured to deter electrical breakdown between the charged particle-optical module and a component external to the charged particle-optical module and/or to confine an electrostatic field within the charged particle-optical module, the electrostatic field for example generated in operation of the one or more charged particle-optical plates on the charged particle beam along the beam path.

According to a second aspect of the invention, there is provided a charged particle-optical module for a charged particle-optical device configured to direct a charged particle beam along a beam path towards a sample location, the charged particle-optical module comprising:
a stack comprising one or more charged particle-optical plates arranged across the beam path and configured to operate on the charged particle beam;
at least one electrical connector configured to connect at least one of the charged particle-optical plates to a voltage supply; and
a shield arrangement configured to extend in a direction across the beam path upbeam of the stack and downbeam of the stack to protrude beyond the connectors.

According to a third aspect of the invention, there is provided a charged particle-optical device configured to direct a charged particle beam along a beam path towards a sample location, the charged particle-optical device comprising:
a conductive tube configured to be around the beam path; and
a charged particle-optical module that comprises:
   a stack comprising one or more charged particle-optical plates arranged across the beam path and configured to operate on the charged particle beam; and
   a shield arrangement configured to shield the stack and to extend in a direction across the beam path upbeam of the stack and in a direction across the beam path downbeam of the stack, the shield arrangement extending further away from the beam path the than conductive tube and the stack.

According to a fourth aspect of the invention, there is provided a method of directing a charged particle beam along a beam path towards a sample location, the method comprising:
operating on the charged particle beam with one or more charged particle-optical plates of a stack, the one or more charged particle-optical plates arranged across the beam path; and
using a shield arrangement comprising an upbeam electrostatic shield arranged across the beam path upbeam of the one or more charged particle-optical plates and a downbeam electrostatic shield arranged across the beam path downbeam of the one or more charged particle-optical plates to deter electrical breakdown between the stack and a component external to the stack and/or to confine an electrostatic field within the shield arrangement, the electrostatic field for example generated in operation of the one or more charged particle-optical plates on the charged particle beam along the beam path.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary electron beam assessment apparatus.
Figure 2 is a schematic diagram illustrating an exemplary multi-beam electron-optical device that is part of the exemplary electron beam assessment apparatus of Figure 1.
Figure 3 is a schematic diagram of an exemplary electron-optical device comprising a collimator element array and a scan-deflector array that is part of the exemplary electron beam assessment apparatus of Figure 1.
Figure 4 is a schematic diagram of an exemplary electron-optical device array comprising the electron-optical devices of Figure 3.
Figure 5 is a schematic diagram of an alternative exemplary electron-optical device that is part of the exemplary electron beam assessment apparatus of Figure 1.
Figure 6 is a schematic diagram of an alternative exemplary electron-optical device that is part of the exemplary electron beam assessment apparatus of Figure 1.
Figure 7 is a schematic diagram of an alternative exemplary electron-optical device that is part of the exemplary electron beam assessment apparatus of Figure 1.
Figure 8 is a schematic diagram of an exemplary electron-optical module that may be part of the electron-optical devices of Figures 2-7.
Figure 9 is a schematic diagram of an exemplary electron-optical module that may be part of the electron-optical devices of Figures 2-7.
Figure 10 is a schematic diagram of an alternative exemplary electron-optical module that may be part of the electron-optical devices of Figures 2-7.
Figure 11 is a schematic diagram of a modified version of the electron-optical module shown in Figure 10.
Figure 12 is a schematic diagram of a modified version of the electron-optical module shown in Figure 10.
Figure 13 is an alternative view of the electron-optical module shown in Figure 10.
Figure 14 is a schematic cross-sectional view of part of an exemplary electron-optical module that may be part of the electron-optical devices of Figures 2-7.
Figure 15 is a schematic diagram of a modified version of the electron-optical module shown in Figure 13.
Figure 16 is a schematic diagram of a modified version of the electron-optical module shown in Figure 15.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by assessment systems (such as a Scanning Electron Microscope (`SEM')) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g. secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g. secondary electrons and/or backscattered electrons) from the target as the target is scanned so that the scanning electron microscope may create an image of the scanned area of the target. A design of electron-optical apparatus embodying these scanning electron microscope features may have a single beam. For higher throughput such as for assessment, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam assessment apparatus may therefore assess a target much quicker, e.g. by moving the target at a higher speed, than a single-beam assessment apparatus.

An implementation of a known multi-beam assessment apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

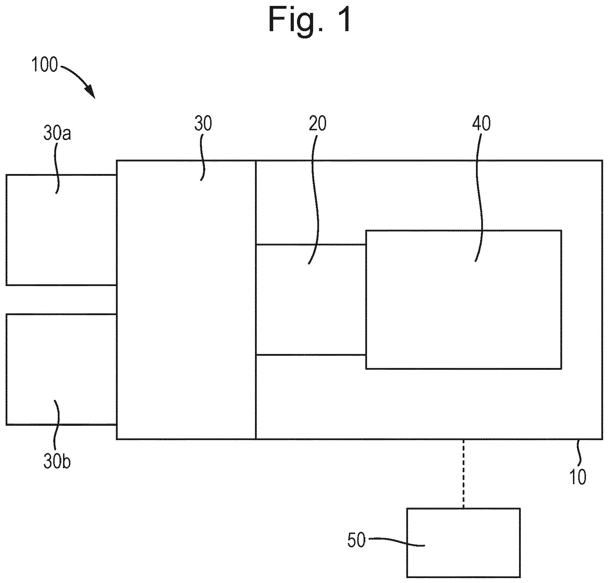

Reference is now made to Figure 1, which is a schematic diagram illustrating an exemplary electron beam assessment apparatus 100, or inspection apparatus. The assessment apparatus 100 of Fig. 1 includes a vacuum chamber 10, a load lock chamber 20, an electron-optical apparatus, an equipment front end module (EFEM) 30 and a controller 50. The electron-optical device 40 may be within the vacuum chamber 10. The electron-optical apparatus may comprise an electron-optical device 40 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be assessed (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the electron-optical device 40 by which it may be assessed. An electron-optical device 40 may comprise either a single beam or a multi-beam electron-optical apparatus.

The controller 50 is electronically connected to the electron-optical device 40. The controller 50 may be a processor (such as a computer) configured to control the charged particle beam assessment apparatus 100. The controller 50 may also include a processing circuitry configured to execute various signal and image processing functions. While the controller 50 is shown in Figure 1 as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it may be distributed over at least two of the component elements. While the present disclosure provides examples of main chamber 10 housing an electron beam assessment apparatus, it should be noted that aspects of the disclosure in their broadest sense are not limited to a chamber housing an electron-optical device. Rather, it is appreciated that the foregoing principles may also be applied to other apparatuses and other arrangements of apparatus that operate under the second pressure.

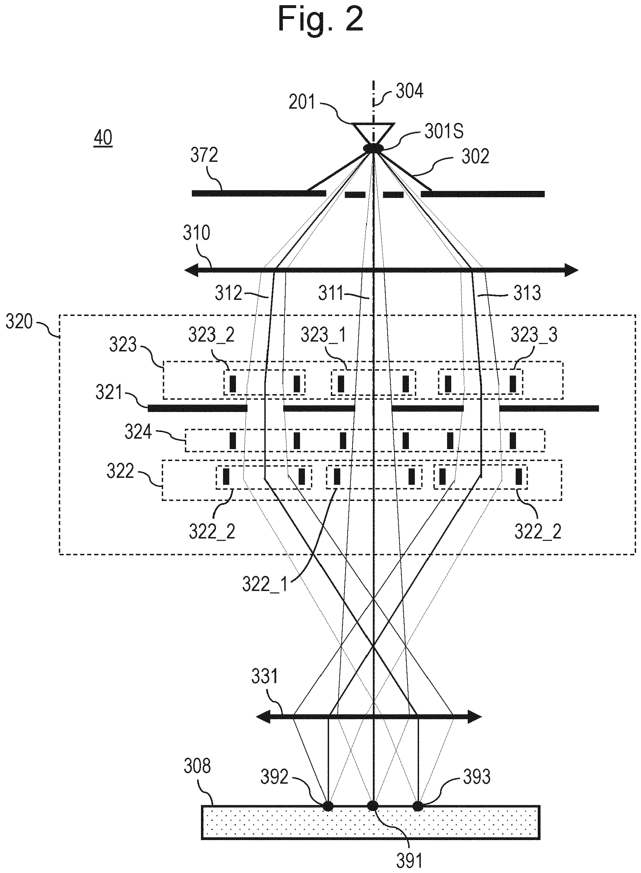

Reference is now made to Figure 2, which is a schematic diagram of an exemplary multi-beam electron-optical device 40 of an assessment apparatus, e.g. the assessment apparatus 100 of Figure 1. In an alternative embodiment the assessment apparatus 100 is a single-beam assessment apparatus. The electron-optical device 40 may comprise an electron source 201, a beam former array 372 (also known as a gun aperture plate, a coulomb aperture array or a pre-sub-beam-forming aperture array), a condenser lens 310, a source converter (or micro-optical array) 320, an objective lens 331, and a target 308. In an embodiment the condenser lens 310 is magnetic. (In a single beam assessment apparatus may have the same features as a multibeam assessment apparatus except electron-optical components with an array apertures 372, 320 may have a single aperture. The source converter 320 may be replaced with a number of electron-optical components along the beam path.) The target 308 may be supported by a support on a stage. The stage may be motorized. The stage moves so that the target 308 is scanned by the incidental electrons. The electron source 201, the beam former array 372, the condenser lens 310 may be the components of an illumination apparatus comprised by the electron-optical device 40. The source converter 320 (also known as a source conversion unit), described in more detail below, and the objective lens 331 may be the components of a projection apparatus comprised by the electron-optical device 40.

The electron source 201, the beam former array 372, the condenser lens 310, the source converter 320, and the objective lens 331 are aligned with a primary electron-optical axis 304 of the electron-optical device 40. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to an electron-optical device 40 with any number of sub-beams such as one, two or more than three. The beam former array 372, in operation, is configured to block off peripheral electrons to reduce the Coulomb effect.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in Figure 2, in an embodiment the electron-optical device 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system upbeam of the main device. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in Figure 2, in an embodiment the electron-optical device 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The electron-optical device 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The electron-optical device 40 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The image-forming element array 322, the aberration compensator array 324, and the pre-bending deflector array 323 may comprise multiple layers of sub-beam electron-optical devices, some of which may be in the form or arrays, for example: micro-deflectors, micro-lenses, or micro-stigmators. Beam paths may be rotationally controlled. Rotational corrections may be applied by a magnetic lens. Rotational corrections may additionally, or alternatively, be achieved by an existing magnetic lens such as the condenser lens arrangement.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

In an embodiment a beam separator (not shown) is provided. The beam separator may be downbeam of the source converter 320. The beam separator may be, for example, a Wien filter comprising an electrostatic dipole field and a magnetic dipole field. The beam separator may be upbeam of the objective lens 331. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons (or signal electrons) generally move in an opposite direction compared to the primary electrons, the magnetic force exerted on the secondary electrons and backscattered electrons (or signal particles) will no longer cancel the electrostatic force and as a result the secondary electrons and backscattered electrons moving through the beam separator will be deflected away from the electron-optical axis 304.

In an embodiment a secondary device (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary device. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons (or signal particles).

Such Wien filter, a secondary device and/or a secondary projection apparatus may be provided in a single beam assessment apparatus. Additionally and/or alternatively a detection device may be present downbeam of the objective lens, for example facing the sample during operation. In an alternative arrangement a detector device is position along the path of the charged particle beam towards the sample. In such an arrangement does not have a Wien filter, a secondary device and a secondary projection apparatus. The detection device may be positioned at one or more positions along the path of the charged particle beam path towards the sample, such as facing the sample during operation, for example around the path of the charged particle beam. Such a detector device may have an aperture and may be annular. The different detector devices may be positioned along the path of the charged particle to detect signal particles having different characteristics. The electron-optical elements along the path of the charged particle beam, which may include one or more electrostatic plates with an aperture for the path of the charged particle beam, may be arranged and controlled to focus the signal particles of different respective characteristics to a respective detector device at different positions along the path of charged particle beams. Such electro-static plates may be arranged in series of two or more adjoining plates along the path of the charged particle beam.

Any element or collection of elements may be replaceable or field replaceable within the electron-optical device. The one or more electron-optical components in the electron-optical device, especially those that operate on sub-beams or generate sub-beams, such as aperture arrays and actuating arrays (e.g. operating or manipulating arrays) may comprise one or more microelectromechanical systems (MEMS). The pre-bending deflector array 323 may be a MEMS. MEMS are miniaturized mechanical and electromechanical elements that are made using microfabrication techniques. In an embodiment the electron-optical device 40 comprises apertures, lenses and deflectors formed as MEMS. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

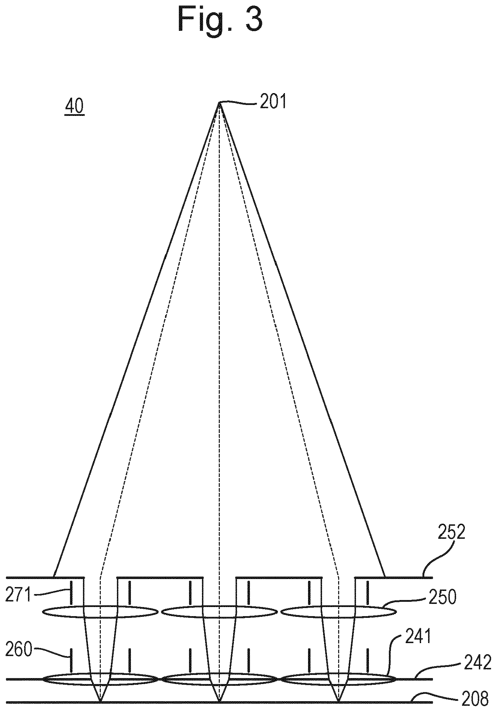

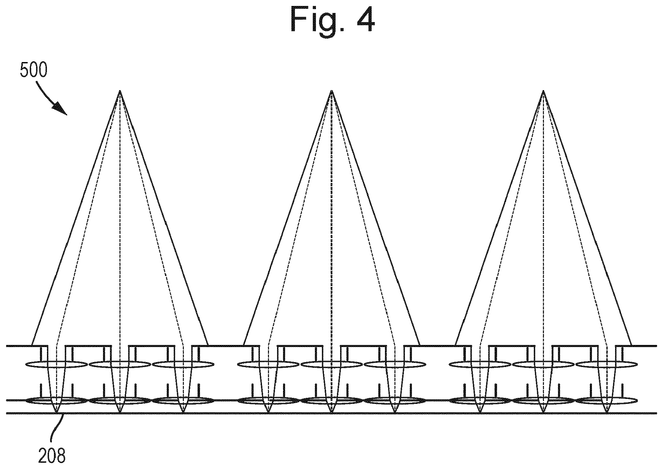

In an embodiment the electron-optical device 40 may comprise alternative and/or additional components on the charged particle path, such as lenses and other components some of which have been described earlier with reference to Figures. 1 and 2. Examples of such arrangements are shown in Figures 3 and 4 which are described in further detail later. In particular, embodiments include an electron-optical device 40 that divides a charged particle beam from a source into a plurality of sub-beams. A plurality of respective objective lenses may project the sub-beams onto a sample. In some embodiments, a plurality of condenser lenses is provided upbeam from the objective lenses. The condenser lenses focus each of the sub-beams to an intermediate focus upbeam of the objective lenses. In some embodiments, collimators are provided upbeam from the objective lenses. Correctors may be provided to reduce focus error and/or aberrations. In some embodiments, such correctors are integrated into or positioned directly adjacent to the objective lenses. Where condenser lenses are provided, such correctors may additionally, or alternatively, be integrated into, or positioned directly adjacent to, the condenser lenses and/or positioned in, or directly adjacent to, the intermediate foci. In some embodiments, a macro condenser lens may be used to collimate a beam projected towards the objective lens instead or as well as the condenser lenses and collimators. A detector is provided to detect charged particles emitted by the sample. The detector may be integrated into the objective lens. The detector may be on the bottom surface of the objective lens so as to face a sample in use. The detector may comprise an array, for example of detector elements, which may correspond to the array of the beamlets of the multi-beam arrangement. The detectors (or detector elements) in the detector array may generate detection signals that may be associated with the pixels of a generated image. Reference to a detector, herein, may be considered to relate to detector array. The condenser lenses, objective lenses and/or detector may be formed as MEMS or CMOS devices.

Figure 3 is a schematic diagram of another design of an exemplary electron-optical device 40. The electron-optical device 40 may comprise a source 201 and one or more electron-optical assemblies. Alternatively, the electron-optical apparatus that comprises the electron-optical device 40 may comprise the source 201. The electron-optical device 40 may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons).

The upper beam limiter 252 defines an array of beam-limiting apertures. The upper beam limiter 252 may be referred to as an upper beam-limiting aperture array or upbeam beam-limiting aperture array. The upper beam limiter 252 may comprise a plate (which may be a plate-like body) having a plurality of apertures. The upper beam limiter 252 forms the sub-beams from the beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided downbeam of the upper beam limiter. Each collimator element collimates a respective sub-beam. The collimator element array 271 may be formed using MEMS manufacturing techniques so as to be spatially compact. In some embodiments, exemplified in Figure 3, the collimator element array 271 is the first deflecting or focusing electron-optical array element in the beam path downbeam of the source 201. In another arrangement, the collimator may take the form, wholly or partially, of a macro-collimator. Such a macro-collimator may be upbeam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit).

As mentioned, the control lens array 250 is associated with the objective lens array 241. As described above, the control lens array 250 may be considered as providing electrodes additional to the electrodes 242, 243 of the objective lens array 241 for example as part of an objective lens array assembly. The additional electrodes of the control lens array 250 allow further degrees of freedom for controlling the electron-optical parameters of the sub-beams. In an embodiment the control lens array 250 may be considered to be additional electrodes of the objective lens array 241 enabling additional functionality of the respective objective lenses of the objective lens array 241.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. The scan-deflector array 260 may thus comprise a scan deflector for each sub-beam. In an embodiment, the scanning deflectors described in EP2425444, which document is hereby incorporated by reference in its entirety specifically in relation to scan deflectors, may be used to implement the scan-deflector array 260. In another arrangement, a macro scan deflector may be used upbeam of the upper beam limiter 252. Its function may be similar or equivalent to the scan-deflector array although it operates on the beam from the source before the beamlets of the multi-beam are generated.

The objective lens array 241 comprising a plurality of objective lenses is provided to direct the sub-beams onto the sample 208. Each objective lens comprises at least two electrodes (e.g. two or three electrodes) connected to respective potential sources.

The objective lens array may form part of an objective lens array assembly along with any or all of the scan-deflector array 260, control lens array 250 and collimator element array 271. The objective lens array assembly may further comprise the beam shaping limiter 242. The beam shaping limiter 242 defines an array of beam-limiting apertures that may shape the cross-section of electron beams that impinge on a sample surface.

In an arrangement, the beam shaping limiter 242 is structurally integrated with an electrode 302 of the objective lens array 241. Desirably, the beam shaping limiter 242 is positioned in a region of low electrostatic field strength. Each of the beam-limiting apertures is aligned with a corresponding objective lens in the objective lens array 241. The apertures of the beam shaping limiter 242 may have a smaller diameter than the apertures of at least another of the aperture arrays in the stack of plates for example comprising the objective lens array. Each beam-limiting aperture has a beam limiting effect, allowing only a selected portion of the sub-beam incident onto the beam shaping limiter 242 to pass through the beam-limiting aperture.

In an embodiment, the electron-optical device 40 is configured to control the objective lens array assembly (e.g. by controlling potentials applied to electrodes of the control lens array 250) so that a focal length of the control lenses is larger than a separation between the control lens array 250 and the objective lens array 241.

An electric power source may be provided to apply respective potentials to electrodes of the control lenses of the control lens array 250 and the objective lenses of the objective lens array 241.

The detector array (not shown) is provided to detect charged particles emitted from the sample 208. The detected charged particles may include any of the charged particles (e.g. signal particles) detected by a scanning electron microscope, including secondary (e.g. emitted) and/or backscattered electrons from the sample 208. The detector may be an array providing the surface of the electron-optical device facing the sample 208, e.g. the bottom surface of the electron-optical device. Alternative the detector array be upbeam of the bottom surface or example in or upbeam of the objective lens array or the control lens array. The elements of the detector array may correspond to the beamlets of the multi-beam arrangement. The signal generated by detection of an electron by an element of the array be transmitted to a processor for generation of an image. The signal may correspond to a pixel of an image.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

In an embodiment, as exemplified in Figure 4, an electron-optical device array 500 is provided. The array 500 may comprise a plurality of any of the electron-optical devices described herein. Each of the electron-optical devices focuses respective multi-beams simultaneously onto different regions of the same sample.

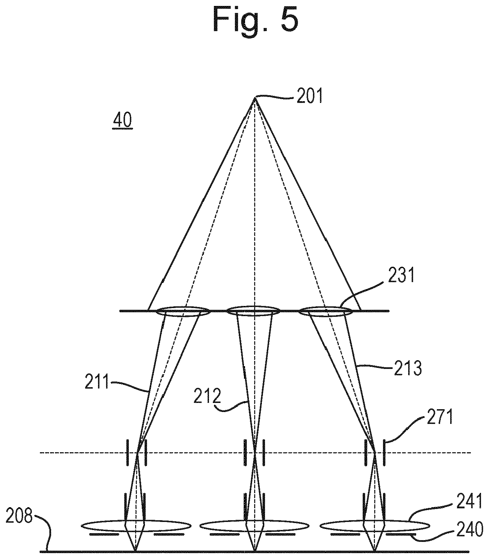

Any number of electron-optical devices may be used in the array 500. Each electron-optical device in the array 500 may be configured in any of the ways described herein when referring to a single electron-optical device, for example as described above, especially with respect to the embodiment shown and described in reference to Figure 5. Details of such an arrangement is described in EPA 20184161.6 filed 6 July 2020 which, with respect to how the objective lens is incorporated and adapted for use in the multi-device arrangement is hereby incorporated by reference.

In the example of Figure 4 the array 500 comprises a plurality of electron-optical devices of the type described above with reference to Figure 3.

An alternative design of multi-beam electron-optical device may have the same features as described with respect to Figure 3 except as described below and illustrated in Figure 5. The alternative design of multi-beam electron-optical device may comprise a condenser lens array 231 upbeam of the object lens array arrangement 241, as disclosed in EP application 20158804.3 filed on 21 February 2020 which is hereby incorporated by reference so far as the description of the multi-beam device with a collimator and its components. Such a design does not require the beam shaping limiter array 242 or the upper beam limiter array 252 because a beam limiting aperture array associated with condenser lens array 231 may shape the beams 211, 212, 213 of the multi-beam.

The paths of the beamlets 211, 212, 213 diverge away from the condenser lens array 231. The beamlets derive from a source beam which towards the condenser lens array has a diverging outer perimeter. The condenser lens array 231 focuses the generated beamlets to an intermediate focus between the condenser lens array 231 and the objective lens array assembly 241 (i.e. towards the control lens array and the objective lens array). The collimator array 271 may be at the intermediate foci instead of associated with the objective lens array assembly 241.

In an embodiment of the arrangement shown in and described with reference to Figure 5, the detector may be located in similar locations in the electron-optical device 40 as described with reference to and as shown in the electron-optical device of Figure 3. The detector 240 may be integrated into the objective lens array 241 and the control lens array 250 (when present as it is not depicted in Figure 5). The detector may have more than one detector at different positions along the paths of the sub-beams of the multibeam.

An electron-optical device array may have multiple multi-beam devices of this design as described with reference to the multi-beam device of Figure 3 as shown in Figure 4. The multiple multi-beam devices may be arranged in an array of multi-beam devices. Such an arrangement is shown and described in EP Application 20158732.6 filed on 21 February 2020 which is hereby incorporated by reference with respect to the multi-device arrangement of a multi-beam apparatus featuring the design of multi-beam device disclosed with a collimator at an intermediate focus. A further alternative design of multi-beam apparatus comprises multiple single beam devices.

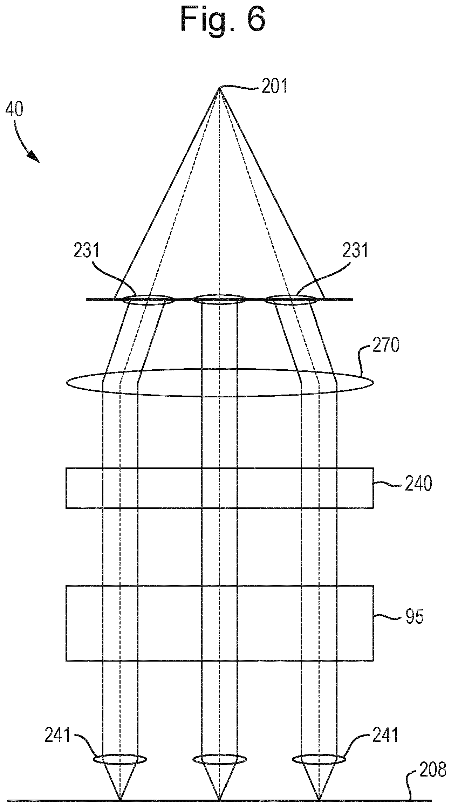

Figure 6 is a schematic diagram of an alternative exemplary electron-optical device 40 that is part of the exemplary electron beam assessment apparatus 100 of Figure 1. Features that are the same as those described above are given the same reference numerals. For conciseness, such features are not described in detail with reference to Figure 6. For example, the source 201, the macro collimator 270, the objective lens array 241 and the sample 208 may be as described above.

In an embodiment the electron-optical apparatus 40 comprises an array condenser lenses 231. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which electrons have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

As described above, in an embodiment the detector 240 is between the objective lens array 241 and the sample 208 (and/or the detector 240 is integrated into the objective lens array 241). The detector 240 may face the sample 208. Alternatively, as shown in Figure 6, in an embodiment the objective lens array 241, which comprises the plurality of objective lenses, is between the detector 240 and the sample 208.

In an embodiment a deflector array 95 is between the detector 240 and the objective lens array 241. In an embodiment the deflector array 95 comprises a Wien filter so that deflector array may be referred to as a beam separator. The deflector array 95 is configured to provide a magnetic field to disentangle the electrons projected to the sample 208 from the signal electrons, e.g. secondary electrons, from the sample 208, for example to distinguish the paths of the electrons projected towards the sample 208 and of signal particles away from the sample.

In an embodiment the detector 240 is configured to detect signal particles by reference to the energy of the electron, i.e. dependent on a band gap. Such a detector 240 may be called an indirect current detector or a silicon based detector. The secondary electrons emitted from the sample 208 gain energy from the fields between the electrodes. The secondary electrodes have sufficient energy once they reach the detector 240. Additionally or alternatively the detector 240 may comprise a scintillator. Such a scintillating detector may be configured to detect electrons above a threshold.

In an embodiment the electron-optical device 40 comprises one or more electron-optical modules 41. In an embodiment the or each electron-optical module 41 is field replaceable. The electron-optical module 41 may be removed from and/or inserted into the electron-optical device 40, without requiring any substantial dismantling of other parts of the electron-optical device 40. That is the electron-optical module 41 may be removable from and/or insertable into the electron-optical device 40.

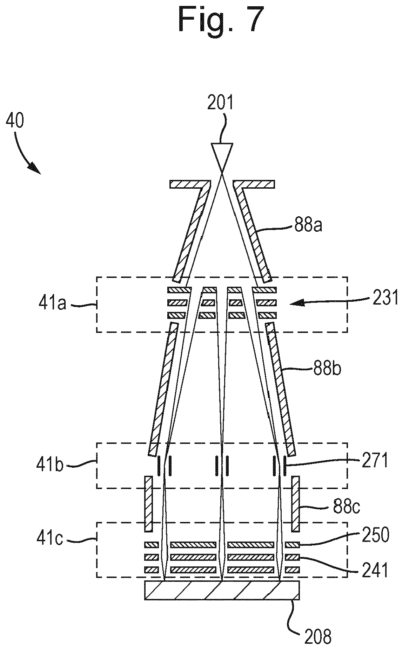

Figure 7 schematically shows how an electron-optical device 40 comprises one or more electron-optical modules 41a, 41b, 41c. Figure 7 is a schematic diagram of an alternative exemplary electron-optical device that is part of the exemplary electron beam assessment apparatus of Figure 1. Such an electron-optical device may have at least the same or at least similar components to those shown in and described with reference to Figure 5.

The electron-optical device 40 is configured to project a multi-beam of electrons along a multi-beam path toward the sample 208. Features of the electron-optical device 40 that are described above are not described again herein, so as to avoid repetition. In an embodiment the electron-optical device 40 comprises a source 201, an array of condenser lenses 231, an array of deflectors 271, a control lens array 250, an array of scan deflectors and an objective lens array 241 as described above.

As shown in Figure 7, in an embodiment the electron-optical device 40 comprises a tube 88 (which may also be called a liner tube or a booster tube). In an embodiment the tube 88 is arranged to surround the multi-beam path. The tube 88 surrounds the multi-beam path for example when viewed along the primary axis of the electron-optical device 40, i.e. in the direction of the electron beam. In an embodiment the tube 88 is configured to surround only part of the multi-beam path, i.e. part of the multi-beam path along the length of the multi-beam path. For example, in an embodiment the tube 88 surrounds the part of the multi-beam path from the source 201 to just above the array of condenser lenses 231. The tube 88 may surround alternative parts, e.g. lengths, of the multi-beam path.

The tube 88 may be at high voltage. For example, the first potential difference may be greater than 100V, optionally at least 200V, optionally at least 500V, optionally at least 1kV, optionally at least 2kV, optionally at least 5kV, optionally at least 10kV, optionally at least 20kV, optionally at least 30kV, and optionally at least 60kV. When the charged particles are negatively charged e.g. electrons, the tube 88 may be at a high positive voltage. Alternatively, when the charged particles are positively charged, the tube 88 may be at a high negative voltage. The tube 88 is configured to cause the electrons of the electron beam to travel through the electron-optical device 40 (i.e. from the source 201 to the sample 208) at high energy.

As shown in Figure 7, in an embodiment the tube 88 comprises at least three sections 88a, 88b, 88c which may be referred to as an up-beam section 88a, an intermediate section 88b and a down-beam section 88c. In an embodiment the sub-beams of electrons (i.e. the multi-beam of electrons) is generated up-beam of the ending of the tube 88, i.e. up-beam of the ending of a down-beam most section 88c of the tube 88. Each section 88a, 88b, 88c of the tube 88 has a termination at its upper end and an ending at its lower end.

As shown in Figure 7, in an embodiment the electron-optical device 40 comprises one or more electron-optical modules 41. In an embodiment an upbeam module 41a comprises the array of condenser lenses 231. In an embodiment an intermediate module 41b comprises the array of deflectors 271. In an embodiment a downbeam module 41c comprises the control lens array 250 and the objective lens array 241. The downbeam module 41c may further comprise an array of scan deflectors and/or a detector. Such a modular concept may be applied to the different electron-optical components of the electron-optical devices 40 shown in and described with reference to Figures 3 to 6.

In an embodiment an electron-optical module 41 located between sections 88a, 88b, 88c of the tube 88. The termination of a section 88a, 88b, 88c of the tube 88 may be inserted into the electron-optical module 41. The ending of a section 88a, 88b, 88c of the tube 88 may be inserted into the electron-optical module 41. Alternatively, an electron-optical module 41 may comprises a section 88a, 88b, 88c of the tube 88.

The electron-optical device 40 may be a component of an assessment apparatus (e.g. for inspection, metrology, metro-inspection or any other type of assessment) or part of an electron beam lithography apparatus or other type of charged particle induced sample patterning apparatus. The multi-beam charged particle apparatus may be used in a number of different applications that include electron microscopy in general, not just scanning electron microscopy, and lithography.

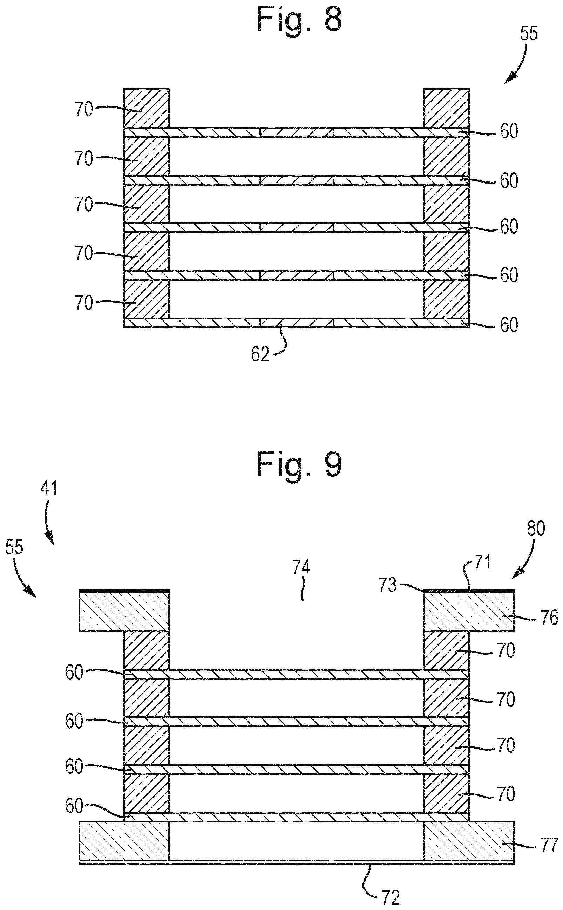

The electron-optical device 40 may comprise an electron-optical module 41 as shown in Figure 8 for operating on electron beamlets. For example, the electron-optical module 41 may comprise one or more of (in a non-limited list): the objective lens array 241, and/or the condenser lens array 231 and/or the collimator element array 271 and/or an individual beam corrector and/or a deflector and/or a Wien filter array. In particular, the objective lens 331 and/or the condenser lens 310 and/or the control lens 250 may comprise the electron-optical module 41.

The electron-optical module 41 is configured to provide a potential difference between two or more plates (or substrates), for example between facing surfaces of adjacent plates along the path of one or more beams. An electrostatic field is generated between the plates, which act as electrodes. The electrostatic field results in an attraction force between the two plates. The attraction force may be increased with increasing potential difference.

Figure 8 schematically depicts an electron-optical module 41. The electron-optical module 41 is configured to direct electrons along at least one beam path towards a sample location. In the orientation shown in Figure 8, the at least one beam path extends vertically from top to bottom through the middle of the electron-optical module 41. There may be one beam path corresponding to one electron beam. Alternatively, there may be a plurality of beam paths corresponding to a plurality of electron sub-beams of a multi-beam.

As shown in Figure 8, in an embodiment the stack 55 of the electron-optical module 41 comprises a plurality of planar elements arranged across the beam path. In an embodiment one or more of the planar elements is an electron-optical plate 60. The electron-optical plate 60 is configured to operate on the one or more electron beams. As shown in Figure 8, in an embodiment all of the planar elements are electron-optical plates 60. Alternatively, one or more of the planar elements may be a planar element other than an electron-optical element. For example, one or more of the planar elements may be an element that is not required to have a voltage applied to it in order for it to perform its function, or the planar element is required to have a voltage applied to it so there is substantially zero potential difference between the element and an adjoining element along the beam path. One example is a planar element that is a beam limiting aperture array comprising apertures dimensioned so as to shape the electron beams. For example, the apertures may allow electron beams of a particular shape to pass through, while blocking other electrons from transmitting through the beam limiting aperture array. As a further alternative, a planar element configured to shape the electron beams may also have a potential difference with respect to an upbeam and/or downbeam planar element such that the electromagnetic field affects the electron beams in addition to the beam shaping function.

As shown in Figure 8, in an embodiment the electron-optical module 41 comprises one or more spacers 70. The spacers 70 are configured to mechanically support the planar elements. As shown in Figure 8, in an embodiment a spacer 70 is configured to mechanically separate planar elements such as electron-optical plates 60 from each other. In an embodiment the spacers 70 are configured to electrically isolate planar elements such as electron-optical plates 60 from each other. However, it is not essential for the spacers 70 to provide electrical isolation. For example, it may be that two adjoining electron-optical plates 60 are arranged to be operated at the same voltage (i.e. having no potential difference between them), in which case electrical isolation may not be required. In an embodiment one or more pairs of adjoining planar elements are directly adjoined to each other, i.e. without an intermediate spacer 70. The spacers 70 are optional features.

The electron beams are configured to pass through the beam area 62 of the electron-optical module 41. As shown in Figure 8, the beam area 62 may be in a mid-portion of the electron-optical module 41; such a mid-portion may be centrally located within the electron-optical module 41. The beam area 62 is located generally centrally when viewed in a direction parallel to the at least one beam path. The beam area 62 is located centrally when viewed in a direction orthogonal to the plane of the planar elements.

In an embodiment the electron-optical module 41 is comprised in an electron-optical device 40, for example an electron-optical device 40 as shown in Figures 2-7. In an embodiment the electron-optical module 41 is field replaceable. The electron-optical module 41 may be removed from and/or inserted into the electron-optical device 40, without requiring any substantial dismantling of other parts of the electron-optical device 40. That is the electron-optical module 41 may be removable from and/or insertable into the electron-optical device 40.

In an embodiment the electron-optical module 41 comprises an objective lens assembly comprising the objective lens array 241. The electron-optical module 41 may further comprise a control lens array 250, a detector 240 and/or a deflector array. In an alternative embodiment, the electron-optical module 41 may be a condenser lens assembly or a collimator array assembly. The electron-optical module 41 may comprise a condenser lens array 231 and/or a collimator array 271. The electron-optical module 41 may further comprise one or more of a deflector array, a beam limiting aperture array, for example.

Figure 9 is a schematic diagram of an electron-optical module 41. The electron-optical module 41 may be part of the electron-optical device 40 shown in any of Figures 2-7, for example. The electron-optical module 41 is for an electron-optical device 40. In an embodiment the electron-optical device 40 is configured to direct an electron beam along a beam path towards a sample location. In an embodiment, the electron-optical module 41 is configured to direct an electron beam along a beam path towards a sample location.

As shown in Figure 9, in an embodiment the electron-optical module 41 comprises a stack 55. The stack 55 may have features as described above with reference to Figure 8. In an embodiment the stack 55 comprises one or more electron-optical plates 60. In an embodiment the one or more electron-optical plates 60 are arranged across the beam path. In the orientation shown in Figure 9, the beam path extends vertically in the direction from top to bottom. The beam path may extend substantially centrally with respect to the width direction of the electron-optical plate 60 shown in Figure 9. Figure 9 shows a cross-sectional view of the electron-optical module 41. The cross-section is taken perpendicular to the plane of the electron-optical plates 60.

In the arrangement shown in Figure 9, the stack 55 comprises four electron-optical plates 60. In an alternative embodiment the stack 55 may comprise no more than one, optionally no more than two, and optionally no more than three electron-optical plates 60. In an embodiment the stack 55 comprises five electron-optical plates 60 (e.g. as shown in Figure 8) or more than five electron-optical plates 60. In an embodiment the electron-optical plates 60 are configured to operate on the electron beam.

As explained above, in an embodiment the electron beam is a multi-beam comprising a plurality of electron sub-beams. In an alternative embodiment, the electron beam is a single electron beam. The electron-optical plate 60 has a functional relationship to the electron beam. As noted elsewhere herein the electron beam may be representative of a plurality of electron beams, such as in a beam grid.

As shown in Figure 9, in an embodiment the electron-optical module 41 comprises a shield arrangement 80. In an embodiment the shield arrangement 80 is provided in addition to the stack 55. In an embodiment the stack 55 comprises the electron-optical components such as the electron-optical plates 60 and the spacers 70. In an embodiment the shield arrangement 80 comprises at least one of the electron-optical plates 60. The shield arrangement 80 may be alternatively referred to as a shielding box, an E-field shielding box or a grounding box, for example.

As shown in Figure 9, in an embodiment the shield arrangement 80 comprises an upbeam electrostatic shield 71. The upbeam electrostatic shield 71 is arranged across the beam path. In an embodiment the upbeam electrostatic shield 71 is upbeam of the one or more electron-optical plates 60. As shown in Figure 9, in an embodiment the shield arrangement 80 comprises a downbeam electrostatic shield 72. The downbeam electrostatic shield 72 is arranged across the beam path. In an embodiment the downbeam electrostatic shield 72 is downbeam of the one or more electron-optical plates 60.

In an embodiment the upbeam electrostatic shield 71 is located at an up side, or top side, of the electron-optical module 41. In an embodiment the downbeam electrostatic shield 72 is provided at a down side, or bottom side, of the electron-optical module 41.

As shown in Figure 9, in an embodiment the upbeam electrostatic shield 71 is substantially planar. In an embodiment the downbeam electrostatic shield 72 is substantially planar. In an embodiment the upbeam electrostatic shield 72 is substantially parallel to the electron-optical plates 60. In an embodiment the downbeam electrostatic shield 72 is substantially parallel to the electron-optical plates 60. The electron-optical plates 60 are located between (in a direction along the beam path) the upbeam electrostatic shield 71 and the down beam electrostatic shield 72.

In an embodiment the shield arrangement 80 is configured to deter electrical breakdown between the electron-optical module 41 and a component external to the electron-optical module 41. For example, electrical breakdown between an electron-optical plate 60 and the sample 208 or an electrical cable may be deterred.

In an embodiment the electron-optical plates 60 are configured to form at least one electrostatic field. The electrostatic field may operate on the electron beam. For example, an electrostatic field may be formed between surfaces of adjacent electron-optical plates 60. In an embodiment the controller 50 is configured to control electric potentials applied to the electron-optical plates 60 so as to control the electrostatic fields formed by the electron-optical plates 60. In an embodiment the controller 50 is configured to control the electric potentials applied to the electron-optical plates 60 so as to control the electron beam.

In an embodiment the shield arrangement 80 is configured to confine an electrostatic field within the electron-optical module 41. The electrostatic field may, for example, be generated in operation of the one or more electron-optical plates 60 on the electron beam along the beam path. The shield arrangement 80 may, to an extent, function as a Faraday cage by reducing or preventing electromagnetic fields from entering or leaving the stack 55.

In an embodiment the shield arrangement 80 is implemented to confine the electric field within the electron-optical module 41, and optionally within the stack 55. The shield arrangement 80 may be configured to reduce, or eliminate, electric fields between the stack 55 and the surroundings of the stack 55. In an embodiment there may remain at least one electric field between the stack 55 and its surroundings. For example, in an embodiment an electric field may remain due to a bias potential on the sample 208.

An embodiment of the invention is expected to reduce discharge risk between the stack 55 and its surroundings. By confining electric fields within the electron-optical module 41, the electric fields are reduced or eliminated, thereby reducing the discharge risk.

An embodiment of the invention is expected to achieve a more compact electron-optical device 40. By providing the shield arrangement 80, the stack 55 may be located closer to its surroundings, without unduly increasing the risk of discharge from/to the surroundings. A more compact design may be realised.

An embodiment of the invention is expected to achieve an increase in design freedom for components surrounding the stack 55. For example, the components surrounding the stack 55 may be allowed to have sharp corners without unduly increasing the risk of discharge between the stack 55 and its surroundings.

An embodiment of the invention is expected to reduce outgassing. For example, by providing the shield arrangement 80, the surface area of insulating material (e.g. potting material) exposed at the exterior of the stack 55 may be reduced. Such insulating material may be more susceptible in general to outgassing. By reducing such exposed surfaces of insulating material, outgassing from the stack may be desirably reduced.

As shown in Figure 9, in an embodiment the upbeam electrostatic shield 71 and the downbeam electrostatic shield 72 are provided at the top and bottom of the electron-optical module 41. The upbeam electrostatic shield 71 and the downbeam electrostatic shield 71 may be configured to confine the electrostatic shields within the stack 55. An embodiment of the invention is expected to reduce problems caused by use of high voltages in the electron-optical module 41 and/or neighbouring modules. Such a neighbouring module may be a physically separated module (i.e. physically separated from the electron-optical module 41). Alternatively, such a neighbouring module may be physically attached to the electron-optical module 41 that may have a similar electric potential as the shield arrangement 80.

As shown in Figure 9, in an embodiment the shield arrangement 80 is configured to extend in a direction across the beam path beyond the one or more electron-optical plates 60. This is shown in Figure 9 where the shield arrangement 80 is wider than the electron-optical plates 60. As shown in Figure 9, in an embodiment the upbeam electrostatic shield 71 and the downbeam electrostatic shield 72 extend in a direction across the beam path beyond the one or more electron-optical plates 60. A greater lateral extension of the shield arrangement 80 may reduce the possibility of undesirable electrical breakdown between the stack 55 and external components. In an embodiment the outer diameter of the upbeam electrostatic shield 71 and/or the downbeam electrostatic shield 72 is at least 10%, optionally at least 20%, optionally at least 50% and optionally at least 100% greater than the outer diameter of the one or more electron-optical plates 60.

As shown in Figure 9, in an embodiment the electron-optical module 41 comprises an insulator 76, 77. The insulator 76, 77 is located at an inwardly facing surface of the shielding arrangement 80. For example, in an embodiment an upbeam insulator 76 is located at an inwardly facing surface of the upbeam electrostatic shield 71. In an embodiment a downbeam insulator 77 is located at an inwardly facing surface of the downbeam electrostatic shield 72. The inwardly facing surface is a surface that faces towards an inner side of the electron-optical module 41. The insulator 76, 77 is provided to deter electrical breakdown between the shield arrangement 80 and another part of the electron-optical module 41, for example one or more of the electron-optical plates 60 and/or one or more electrical connectors 84.

As shown in Figure 9, in an embodiment in the shield arrangement 80 is defined at least an opening 74. In an embodiment at least one of the upbeam electrostatic shields 71 and the downbeam electrostatic shields 72 comprises an opening 74 for the beam path. For example, Figure 9 shows that the upbeam electrostatic shield 71 comprises such an opening 74. The beam path extends through the opening 74. As shown in Figure 9, in an embodiment the opening 74 is defined with in a radially inward peripheral surface 73. In an embodiment the opening 74 is central in the electron-optical module 41. For example, the opening 74 may be central relative to the stack 55. In an embodiment the radially inward peripheral surface 73 faces the opening 74 around the beam path.

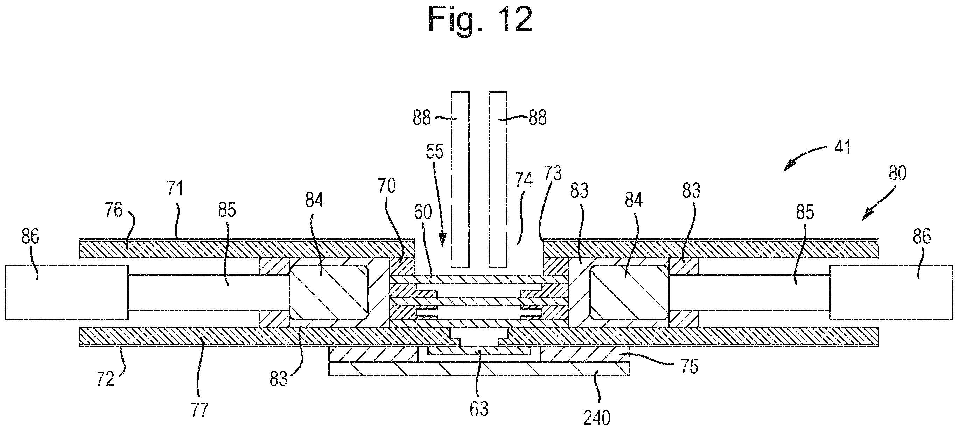

By providing the opening 74, the shield arrangement 80 may be open to an extent (i.e. not completely closed). Such an opening 74 may be provided on top of the stack 55, as shown in Figure 9, and/or at the bottom of the stack 55. In an embodiment such an opening 74 allows for the entry of a tube 88, for example into a volume of the stack (for example as described in more detail below and shown in Figure 12, Figure 15 and Figure 16, for example).

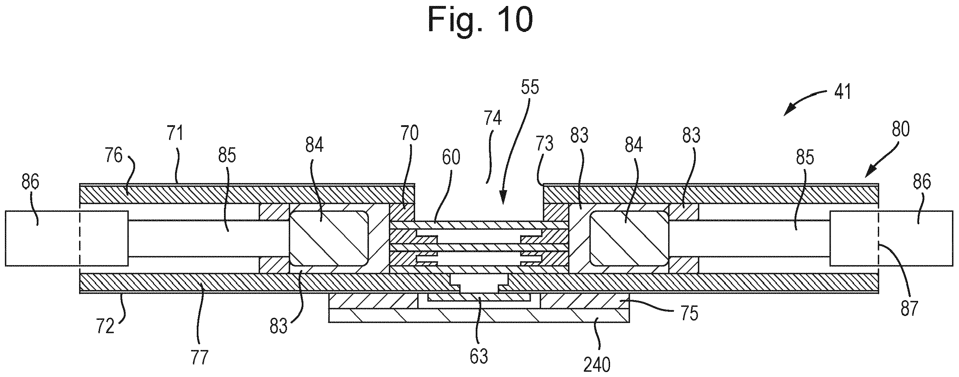

Figure 10 is a schematic diagram of an alternative arrangement of an electron-optical module 41. The electron-optical module 41 may be part of the electron-optical device 40 shown in any of Figures 2-7, for example. In order to reduce redundant description, features of the electron-optical module 41 shown in Figure 10 that are substantially the same as corresponding features described above are not described again below, such as in the following text.

As shown in Figure 10, in an embodiment the electron-optical module 41 comprises at least one electrical connector 84. The electrical connector 84 is configured to connect at least one of the electron-optical plates 60 to a voltage supply. The voltage supply may supply a voltage so that the electron-optical plate 60 is at a target electric potential. In an embodiment the controller 50 is configured to control the voltage supplied by the voltage supply through the electrical connector 84 to the electron-optical plate 60.

In an embodiment the voltage supply is configured to supply the electric potential such that a potential difference between at least one of the electron-optical plates 60 and the shield arrangement 80 is at least 1 kV, optionally at least 2 kV, optionally at least 5 kV, optionally at least 10 kV, optionally at least 20 kV and optionally at least 30 kV. In an embodiment the voltage supply is configured to supply the electric potential such that a potential difference between at least one of the electron-optical plates 60 and the shield arrangement 80 is in the range of from about 1 kV to about 40 kV.

As shown in Figure 10, in an embodiment the shield arrangement 80 is configured to extend in a direction across the beam path to protrude beyond the at least one electrical connector 84. As shown in Figure 10, in an embodiment the shield arrangement 80 is configured to protrude beyond the at least one electrical connector 84 upbeam of the stack 55 and downbeam of the stack 55.

The at least one electrical connector 84 may form an electrostatic field, such as in operation. In an embodiment the shield arrangement 80 is configured to shield a component that is external to the electron-optical module 41 from electrical discharge with the at least one electrical connector 84. Such an external component may be a surface that corresponds in shape to a surface of the module 41. The surface of the external component may face a surface of the module such as of the shield arrangement 80. The external surface and the shield arrangement 80 face each other, for example are co-planar with respect to each other. The external surface may define a chamber wall defining the device 40. There may be a small displacement, or gap, between the external surface and the shield arrangement 80. In an embodiment the shield arrangement 80 is configured to shield electrostatic fields generated within the electron-optical module 41.

As shown in Figure 10, in an embodiment the shield arrangement 80 comprises an upbeam electrostatic shield 71 arranged across the beam path to extend in the direction across the beam path upbeam of the stack 55. The surface of the external component may face a surface of an electrostatic shield, such as the upbeam electrostatic shield 71. In an embodiment the shield arrangement 80 comprises a downbeam electrostatic shield 72 configured to extend in the direction across the beam path downbeam of the stack 55. In an embodiment the shield arrangement 80 extends radially (i.e. in the direction across the beam path) so as to shield the at least one electrical connector 84. In an embodiment the shield arrangement 80 extends in a direction across the beam path so as to deter electrical breakdown between the at least one electrical connector 84 and a component external to the electron-optical module 41.

In an embodiment the upbeam electrostatic shield 71 and the downbeam electrostatic shield 72 are configured to have a common potential. The electric potential applied to the upbeam electrostatic shield 71 may be substantially the same as the electric potential applied to the downbeam electrostatic shield 72. In an embodiment the upbeam electrostatic shield 71 and the downbeam electrostatic shield 72 are electrically connected to each other. Alternatively, the upbeam electrostatic shield 71 may be electrically isolated from the downbeam electrostatic shield 72. The upbeam electrostatic shield 71 may be connected to first voltage supply so that the upbeam electrostatic shield 71 is at a first electric potential. The downbeam electrostatic shield 72 may be connected to a second voltage supply. The second voltage supply may be configured to apply the first electric potential to the downbeam electrostatic shield 72. Alternatively, there may be a small difference between the electric potential supplied to the upbeam electrostatic shield 71 and the downbeam electrostatic shield 72.

In an embodiment the upbeam electrostatic shield 71 is mechanically and electrically connected to the downbeam electrostatic shield 72. For example, in an embodiment an electrical connection 87 is provided between the upbeam electrostatic shield 71 and the downbeam electrostatic shield 72. In an embodiment the electrical connection 87 comprises an electrically conductive adhesive (e.g. a conductive glue), an electrically conductive clamp and/or a fixing such as a screw. By providing the upbeam electrostatic shield 71 and the downbeam electrostatic shield 72 at the same or similar electric potential, electric fields may be confined within the stack 55. The electrical connection 87 is shown by a dashed line in Figure 10. Further, the potential of the facing surfaces of an electrostatic shield, such as the upbeam electrostatic shield 71 and of the external surface, may be arranged to have the same, or at least a similar, potential. For these facing surfaces to have the same or substantially similar potentials, the risk of unwanted discharge to the external surface may be reduced.

As shown in Figure 9, in an embodiment at least part of the shield arrangement 80 comprises a conductive layer, such as an electrically conductive coating, on an insulator 76, 77. For example, as shown in Figure 9, in an embodiment the upbeam electrostatic shield 71 comprises a conductive coating (i.e. a conductive layer) on an upbeam insulator 76. The upbeam insulator 76 may be planar. In an embodiment the upbeam insulator 76 is substantially parallel to the electron-optical plates 60.

As shown in Figure 10, in an embodiment at least part of the downbeam electrostatic shield 72 comprises a layer, such as coating, on a downbeam insulator 77. The coating may be electrically conductive. The downbeam insulator 77 may be planar. The downbeam insulator 77 may be substantially parallel to the one or more electron-optical plates 60. The shield arrangement 80 may be formed by two large plates that function as insulators, for example as two insulating plates namely the upbeam insulator 76 and the downbeam insulator 77 (which may be spacers) that have an electrically conductive exterior surface, for example as an outside coating. Note: further reference herein to coating, can be considered to be provision of a conductive surface, and/or an electrically conductive layer, for example of limited thickness.

An embodiment of the invention is expected to reduce voltage instability and/or partial discharges. By providing a conductive coating to form at least part of the shield arrangement 80, the possibility of voids or gaps at the interior side of the shield arrangement 80 is reduced. A conductive coating may be applied to an insulator 76, 77 with substantially no gap or void between the conductive coating and the insulator 76, 77. Voids or gaps can otherwise result in local field enhancement, which can result in partial discharges and thereby voltage instability.

It is not essential for at least part of the shield arrangement 80 to be provided as a conductive coating. As shown in Figure 9, in an embodiment the shield arrangement 80 may be provided by one or more electrically conductive plates. For example, the downbeam electrostatic shield 72 may be provided as an electrically conductive plate adjacent to the downbeam insulator 77. In an embodiment an electrically insulating filling material such as a potting material may be provided between such an electrically conductive plate forming the downbeam electrostatic shield 72 and the downbeam insulator 77. The filling material may reduce the occurrence of voids or gaps between the downbeam electrostatic shield 72 and the downbeam insulator 77. In the same way, in an embodiment the upbeam electrostatic field 71 is formed as an electrically conductive plate adjacent to the upbeam insulator 76.

As shown in Figure 10, in an embodiment the at least one electrical connector 84 is configured to electrically connect an electrical cable 85 to one or more of the electron-optical plates 60. The electrical cable 85 may be a high voltage cable. In an embodiment the electrical cable 85 is non-shielded. For example, the electrical cable 85 may be provided with only inner insulation around the electrical conductor. As shown in Figure 10, in an embodiment the electrical cable 85 is configured to electrically connect the electrical connector 84 to a cable shielding termination 86. In an embodiment the cable shielding termination 86 is a high voltage cable shielding termination.

As shown in Figure 10, in an embodiment the shield arrangement 80 has openings at the cable entry points (i.e. between the upbeam electrostatic shield 71 and the downbeam electrostatic shield 72) at the sides of the diagram shown in Figure 10. In an embodiment the cable shielding termination 86 has the same or similar electric potential to the shield arrangement 80. No electric field, or a very limited electric field, is expected to leak out of the shield arrangement 80. That is, the electric field is substantially contained, for example by the shield arrangement 80. As shown in Figure 10, in an embodiment the shield arrangement 80 extends in a direction across the beam path to the cable shielding termination 86.

In an embodiment the insulator 76, 77 comprises a glass. For example, the upbeam insulator and/or the downbeam insulator 77 is a glass plate. An electrically conductive coating may be applied to the outwardly facing surface of the glass plate to function as part of the shield arrangement 80. In an embodiment insulating material, such as insulating potting, is provided to fill any gap between the glass plate and the electron-optical plates 60 and/or the at least one electrical connector 84. Note: although two elements are described: the glass plate and insulating material, alternative well known arrangements may be used for the volume of the glass plate and the potting to be insulating, for example they may be integrated with each other such as in a monolithic element. This can help to prevent field enhancement in any voids near the electron-optical plates 60 and/or the at least one electrical connector 84. Such potting material 83 is shown in Figure 10, for example between the electrical connectors 84 and the upbeam insulator 76 and the downbeam insulator 77.

As shown in Figure 10, in an embodiment a gap is provided between the electrical cable 85 and the insulators 76, 77. It may not be necessary to fill such a gap with potting because the exterior surface of the electrical cable 85 and the facing surface of the insulator 76, 77 are both electrically insulating.

As mentioned above, in an alternative embodiment the shield arrangement 80 is provided by electrically conductive plates, instead of by an electrically conductive coating on an insulator. In an embodiment an insulating material is provided at the inward facing surface of the electrically conductive plates so as to reduce the possibility of discharge to the charged parts within the stack 55.

In an embodiment between at least part of one or more surfaces of the shield arrangement 80 and the stack 55 is comprised a filling material such as potting material 83. The filling material such as potting material 83 is provided so as to substantially avoid gaps between the shield arrangement 80 and the insulator 76, 77.

As shown in Figure 10, in an embodiment the electron-optical plates 60 of the stack 55 comprise a downbeam plate 63. The downbeam plate 63 may be an electrode of an electrostatic lens comprised of two or more plates, such as the objective lens. As such, the downbeam plate may be referred to as an objective lens bottom electrode, for example by reference to the plate comprising part of the objective lens and the position of the downbeam plate 63 within the objective lens relative to the beam path. As shown in Figure 10, in an embodiment the downbeam plate 63 is electrically connected to the electrically conductive coating on the downbeam insulator 77. In a different arrangement the downbeam plate has a separate electrical connection than the electrically conductive surface, for example of the electrically conductive coating. The downbeam plate 63 may be set a different potential from the electrically conductive surface.

In an embodiment the shield arrangement 80 comprises one or more of the electron-optical plates 60 of the stack 55. For example, at least one of the upbeam electrostatic shield 71 and the downbeam electrostatic shield 72 may comprise at least one of the electron-optical plates 60. For example, in the arrangement shown in Figure 10, the downbeam plate 63, which is one of the electron-optical plates 60 of the stack 55, is comprised as part of the downbeam electrostatic shield 72. The downbeam plate 63 may be at the same electric potential as the rest of the shield arrangement 80. In an embodiment the electron-optical plate, such as the downbeam plate 63, that is comprised in the shield arrangement 80 reduces the extent to which the shield arrangement 80 is open, for example to the external environment such as to contain an electrostatic field. The downbeam plate 63 substantially closes what would otherwise be another opening 74 in the downbeam electrostatic shield 72, or at least reduces an open area of the opening 74 in the downbeam electrostatic shield 72.

As shown in Figure 9, in an embodiment the stack 55 comprises at least one spacer 70. In an embodiment the spacer 70 is configured to support and/or electrically isolate at least one of the electron-optical plates 60. For example, in an embodiment an individual spacer 70 is located between a pair of the electron-optical plates 60.

In an embodiment the shield arrangement 80 comprises at least one spacer such as the upbeam insulator 76 comprised in the upbeam electrostatic shield and/or the downbeam insulator 77 comprised in the downbeam electrostatic shield.

As shown in Figure 10, in an embodiment at least one of the spacers 70 is arranged around one of the electron-optical plates 60. Such a spacer 75 may be referred to as a radial spacer. For example, in the arrangement shown in Figure 10, the radial spacer 75 is arranged radially around the downbeam plate 63. In an embodiment the radial spacer 75 is radially spaced from the downbeam plate 63. As shown in Figure 10, in an embodiment the radial spacer 75 is arranged around one of the electron-optical plates 60 such that the electron-optical plate 60 (e.g. the downbeam plate 63) is located between the beam path and the radial spacer 75.

As shown in Figure 10, in an embodiment the radial spacer 75 is configured to space the electron-optical plate 60 (e.g. the downbeam plate 63) away from another component of the electron-optical module 41 in a direction along the beam path. In an embodiment the radial spacer 75 is configured to space the electron-optical plate 60 (e.g. the downbeam plate 63) away from another electron-optical plate. For example, as shown in Figure 10, in an embodiment the radial spacer 75 is configured to space the downbeam plate 63 from the detector 240. The detector 240 may be an electron-optical plate.

As shown in Figure 10, in an embodiment the detector 240 and the radial spacer 75 (which may also be referred to as a detector spacer) are mounted on the exterior of the shield arrangement 80. In an embodiment the detector 240 is at the same electric potential as the shield arrangement 80. It is desirable that the detector 240 and the shield arrangement are at the same potential. The detector 240 may be regarded as part of the shield arrangement 80. In an embodiment the radial spacer 75 is electrically conductive. The radial spacer 75 may electrically connect the detector 240 to the electrically conductive coating provided on the downbeam insulator 77.

By providing that the downbeam plate 63 is electrically connected to the electrically conductive coating, the downbeam plate 63 may have a target electric potential applied to it without requiring a separate electrical connection for the downbeam plate 63. In an alternative embodiment, the downbeam plate 63 is electrically isolated from the electrically conductive coating. In an embodiment a separate electrical connection is provided between the downbeam plate 63 and a voltage supply.

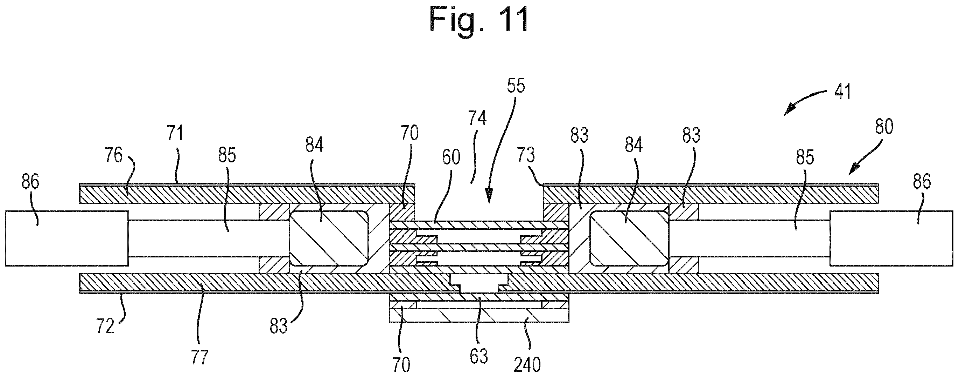

It is not essential for the radial spacer 75 to be provided. Figure 11 is a schematic diagram of a modified version of the electron-optical module 41 shown in Figure 10. As shown in Figure 11, in an embodiment a radial spacer is not provided. Instead, a spacer 70 at the downbeam side of the electron-optical module 41 is provided between the downbeam plate 63 and the detector 240. The shield arrangement 80 is configured to extend radially.

As shown in Figure 10, in an embodiment at least one of the electron-optical plates 60 comprises a detector 240 arranged across the beam path. In an embodiment the detector 240 is configured to detect electrons from the sample location. In an embodiment the detector 240 comprises a detector array. In an embodiment the detector array comprises detector elements. Figure 10 is an exemplary embodiment. In different embodiments, the detector 240 may be located in one or more different positions in the stack 55.

Figure 12 is a schematic diagram of an electron-optical module 41. The electron-optical module 41 shown in Figure 12 may be considered to be a modified version of the electron-optical module 41 shown in Figure 10. However, in a different arrangement, the new features shown in and described with reference to Figure 12 relative to Figure 10 may be applied to the arrangement shown and described with reference to Figure 11.

As shown in Figure 12, in an embodiment the electron-optical module 41 comprises a tube 88 (or tube portion). In an embodiment the tube 88 is configured to be around a portion of the beam path. In an embodiment the tube portion is in contact with an electron-optical plate 60. In an embodiment the tube 88 is joined to one of the electron-optical plates 60, for example to the upbeam plate 64. In an embodiment a gap is provided between the two sections of the tube 88. Alternatively, as shown in Figure 12, the tube 88 may be physically separate from the electron-optical plates 60 of the stack 55.

As shown in Figure 12, in an embodiment the tube 88 is configured to protrude through an opening 74. The opening 74 is defined in the shield arrangement 80. In an embodiment the opening 74 is defined in one of the upbeam electrostatic shield 71 and the downbeam electrostatic shield 72.

In an embodiment the tube 88 is positioned away from a surface of the opening 74. For example, the tube 88 may be separate from, i.e. distal from, the inward facing peripheral surface 73 that defines the opening 74. In an embodiment the tube 88 is conductive. As shown in Figure 12, in an embodiment the shield arrangement 80 extends further away from the beam path than the conductive tube 88 and the stack 55. The tube 88 may be part of a tube 88 (for example its sections 88a, 88b and 88c) as shown and described with reference to Figure 7. The shield arrangement 80 may extend further away from the beam path for example orthogonally from the beam path than the tube 88 and the stack 55.

As shown in Figure 12, in an embodiment the tube 88 is distanced from the electron-optical module 41. As shown in Figure 12, in an embodiment the tube 88 is distanced from at least the shield arrangement 80 of the electron-optical module 41.

Alternatively, the tube 88 may be in electrical contact with a peripheral electron-optical plate of the stack 55, for example a most upbeam, or top, plate 60 of the stack 55. In an embodiment the tube 88 comprises at least a tube portion which is in contact with a peripheral electron-optical plate 60 of the stack 55, such as a most upbeam plate 60 of the stack 55.

Whether or not the tube 88 is connected to the electron-optical plate 60, at least part of the tube 88 may be set to a potential. The tube 88 may be set to a potential that is the same or similar to the potential applied to a peripheral electron-optical plate 60 of the stack 55.

As shown in Figure 12, in an embodiment the tube 88 extends through a beam opening 74 defined in one of the upbeam electrostatic shield 71 and the downbeam electrostatic shield 72. In particular in the arrangement shown in Figure 12, the tube 88 extends through the opening 74 defined in the upbeam electrostatic shield 71. In an embodiment the opening 74 is positioned towards a middle region of a dimension across the dimension of the beam path. For example, the opening 74 may be in the shield arrangement 80 between opposite sides. The opposite sides may be equidistant from the opening 74. In an embodiment the electron-optical device 40 comprises an individual tube 88 configured to extend through the upbeam electrostatic shield 71 and another individual tube configured to extend through the downbeam electrostatic shield 72.

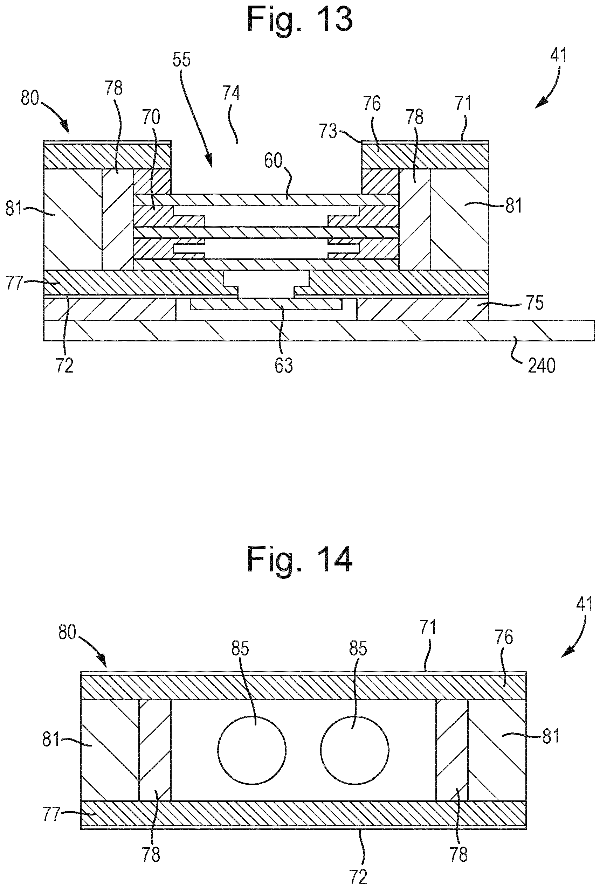

Figure 13 is a schematic diagram showing a different view of the electron-optical module 41 shown in Figure 10. As shown in Figure 13, in an embodiment the shield arrangement 80 comprises at least one side shield 81. The at least one side shield 81 is located to a side of the electron-optical plates 60 in a direction in a plane across the beam path. In an embodiment the side shield 81 is configured to contribute to the confinement of electrostatic fields within the electron-optical module 41. In an embodiment the side shield 81 is configured to deter electrical breakdown between the electron-optical module 41 and a component external to the electron-optical module 41. In an embodiment the side shield 81 is configured to deter electrical breakdown between the electron-optical module 41 and a component to the side of the electron-optical module 41. In an embodiment the side shield 81 is a side electrostatic shield.

As shown in Figure 13, in an embodiment the shield arrangement 80 is formed by the upbeam electrostatic shield 71 and the downbeam electrostatic shield 72 in addition to a side shield 81 on either side of the stack 55. As shown in Figure 13, in an embodiment the at least one side shield 81 connects to both the upbeam insulator 76 and the downbeam insulator 77.

In an embodiment the side shields 81 are electrically connected to each other and/or to the upbeam electrostatic shield 71 and the downbeam electrostatic shield 72. For example, electrical connection may be provided by one or more of an electrically conductive adhesive, an electrically conductive clamp and electrically conductive fixing such as a screw. It is not essential for the side shields 81 to be electrically connected to each other or to the upbeam electrostatic shield 71 or the downbeam electrostatic shield 72. There may be a small gap between one of the side shields 81 an adjoining one of the upbeam electrostatic shield 71 and the downbeam electrostatic shield 72 In an alternative embodiment, the side shields 81 are independently connected to voltage supplies that apply similar or the same electric potentials to the side shields 81 as to each other and to the upbeam electrostatic shield 71 and the downbeam electrostatic shield 72. The shield arrangement 80 is configured to confine electric fields within the stack 55.

As shown in Figure 13, in an embodiment the at least one side shield 81 extends upbeam beyond the one or more electron-optical plates 60. In an embodiment the at least one side shield 81 extends downbeam beyond the one or more electron-optical plates 60. The side shields 81 are configured to reduce the possibility of electrical breakdown between the stack 55 and components to the side of the stack and external to the electron-optical modules 41.

In an embodiment the at least one side shield 81 comprises a conduit for a flow of thermal conditioning fluid. The thermal conditioning fluid is for thermally conditioning the electron-optical module 41. Additionally or alternatively, one or more of the side shields 81 comprises an electrically conductive body such as a metal body or metal block. The metal body may comprise a respective conduit. The side shields 81 may be provided as electrically conductive blocks on either side of the stack 55. The metal blocks may have a thermal conditioning function, so the metal blocks may function as cooling channels.

Figure 14 is a schematic diagram of a cross-section through the electron-optical module 41 shown in Figure 13 and Figure 10. In Figure 14, the cross-section that is through the electrical cables 85. As shown in Figure 13 and Figure 14, in an embodiment a side insulator 78 is provided at an inward facing surface of the side shields 81. As shown in Figure 13, in an embodiment the side insulator 78 is configured to reduce the possibility of electrical breakdown between the side shields 81 and the electron-optical plates 60 of the stack 55. In an embodiment the side insulator 78 is configured to reduce the possibility of voids or gaps at the inner facing surface of the side shields 81. By reducing the occurrence of voids or gaps, local electric field enhancement can be reduced, thereby reducing the possibility of undesirable electrical breakdown.

As shown in Figure 13, in an embodiment a filling material such as a potting material may substantially fill the volume between the side shield 81 and the stack 55.

As shown in Figure 14, in an embodiment the side insulator 78 is configured to cover the inner facing surface of the side shield 81. In an embodiment a void is provided between the side insulator 78 and the electrical cable 85. This does not unduly increase the risk of undesirable electrical breakdown because the outward facing surface of the electrical cable 85 is electrically insulating and the inward facing surface of the side insulator 78 is electrically insulating.

As mentioned above, in an embodiment a portion of the electrical cable 85, such as proximate to the stack 55, may be unshielded, for example an electrically conductive element of the cable may be bare (i.e. a bare portion); that is without an insulating cover or surface. The bare portion may enable an effective electrical connection of the electrical cable 85 to a connector of the stack for connecting one or more respective plates 60. It is noted that the bare portion is shielded by the shield arrangement 80. For the shield arrangement to shield effectively the bare potion of the cable 85, a distal end of the bare portion of the cable away from the stack 55, is recessed sufficiently within the shielding arrangement 80 to suppress if not prevent unwanted discharge from the bare portion and otherwise suppress electrical breakdown. That is the elements of the shielding arrangement 80 such as the upbeam electrostatic shield 71, the downbeam electrostatic shield 72 and the side shields 81 may protrude away from the stack (for example the beam path) and with sufficient distance from the distal end of the bare portion to suppress if not prevent electrical discharge. In an embodiment the electrical cable 85, such as of the bare portion, may be at a positive potential relative to the shield arrangement 80. Alternatively, the shield arrangement 80 may be considered to be negatively charged with respect to the electrical cables 85. By having all surfaces facing the electrical cables 85 made from electrical insulators and having the elements of the shielding arrangement 80 extend outward from the stack surrounding ends of the electrical cables 85, the possibility of undesirable discharge towards the electrical cables 85 is reduced. As shown in Figure 14, in an embodiment the surfaces facing the cables 85 are made from insulators by providing the upbeam insulator 76, the downbeam insulator 77 and the side insulators 78.

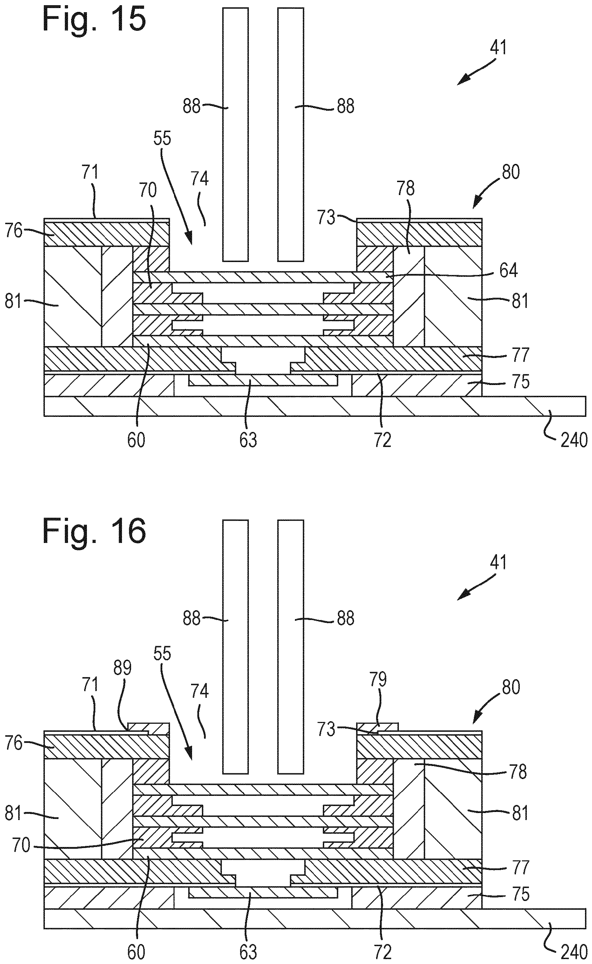

As shown in Figure 12, in an embodiment a tube 88 is provided through the opening 74. Figure 15 is a schematic diagram showing such a tube 88 extending through the opening 74 at the upbeam side of the electron-optical module 41. In an embodiment the most upbeam of the electron-optical plates 60 (i.e. the upbeam plate 64 shown in Figure 15) may be at a positive potential relative to the shield arrangement 80. Alternatively, the shield arrangement 80 may be considered to be negatively charged with respect to the upbeam plate 64. In an embodiment the tube 88 is positively charged relative to the shield arrangement 80 (or the shield arrangement 80 may be considered to be negatively charged relative to the tube 88).

Figure 16 is a schematic diagram of a modified version of the electron-optical module 41 shown in Figure 15. As shown in Figure 16, in an embodiment the electron-optical module 41 comprises an insulating cover 79. The insulating cover may be an insulating layer, such as a coating such of insulating material, i.e. as an insulating coating. The insulating cover 79 is configured to cover the radially inward peripheral surface 73 of the electrostatic shield 71. The insulating cover 79 may be annular, may be planar and may be a ring. For example, the insulating cover 79 may be configured to define the limit of a coating on one or both of the upbeam electrostatic shield 71 and the downbeam electrostatic shield 72. As shown in Figure 16, in an embodiment the insulating cover 79 is configured to cover an edge of a coating on a respective one of the upbeam electrostatic shield 71 and the downbeam electrostatic shield 72. In an embodiment the insulating cover 79 is configured to define the limit of the coating.

An embodiment of the invention is expected to reduce the possibility of electrical breakdown between the shield arrangement and either the tube 88 or the upbeam plate 64. Field enhancement may occur at the edge of the coating facing the tube 88 or the upbeam plate 64. Such field enhancement could result in the release of electrons and subsequent discharge towards either the tube 88 or the upbeam plate 64. By providing the insulating cover 79, such field enhancement is reduced if not prevented.

As shown in Figure 16, in an embodiment the insulating cover 79 encapsulates the coating edge facing the tube 88 and the upbeam plate 64. Local field enhancement that might otherwise occur in or on the insulator may be reduced or prevented.

A triple point 89 may be defined where an electrical conductor, an electrical insulator and the environment meet. Such a triple point is shown in Figure 16 defined where the coating that forms the upbeam electrostatic shield 71 meets the insulating cover 79 and the gas in the environment. This triple point is located where the electric field is low. Relative to an arrangement without the insulating cover 79, positioning the triple point away from a sharp edge relatively diminishes the field. Therefore, a reduced risk, or no particular risk, of electrical breakdown is expected from more to such a triple point. Meanwhile, no triple point is provided in the region of higher electrical fields i.e. in the region between the shield arrangement 80 and the liner tube 88 or the upbeam plate 64 of the stack 55. That is use of the insulating cover 79 moves the triple point from between vacuum, coating of the electrostatic shield 71 and insulator 76 to a location of the upper electrostatic shield 71 having lower risk of discharge.

In an embodiment the tube 88 has rounded edges. By providing rounded edges, field enhancement caused by sharp edges may be reduced or prevented. This may reduce the possibility of electrical breakdown from the tube 88 towards the shield arrangement 80. This may be desirable when the tube 88 is negatively charged relative to the shield arrangement 80.

As shown in Figure 12, in an embodiment electrical connectors 84 are provided on two different sides of the stack 55. In an alternative embodiment, electrical connectors 84 are provided on only one side of the stack 55. Such an arrangement of the stack 55 may have a single cooling conduit which extends around more than one side of the electron-optical module, for example two or three sides of the module 41. In an alternative embodiment, electrical connectors 84 are provided on more than two sides of the stack 55. For example, in an embodiment the stack 55 when viewed in a direction along the beam path may be triangular, square, pentagonal, hexagonal or circular, for example. A cooling conduit may extend along two or more adjoining sides of such a shaped stack 55. Electrical connections with electrical connectors 84 may be provided at any or all of the sides of the stack 55. In an embodiment a side shield 81 is provided on each side of the stack 55 where it is not necessary to provide an electrical connector 84. For example, in an embodiment the stack 55 is square or rectangular (i.e. having four sides) when viewed from along the beam path. In an embodiment all of the electrical connectors 85 are provided at the same side of the stack 55. Side shields 81 may be provided at the other three sides of the stack 55.

In an embodiment the electron-optical module 41 shown in Figures 10-16 may correspond to the downbeam module 41c shown in Figure 7. The downbeam module 41c may comprise for example the control lens array 250, the objective lens array 241 and the detector 240. In an alternative embodiment, the electron-optical module 41 corresponds to the upbeam module 41a or the intermediate module 41b shown in Figure 7. In an embodiment, a section of tube 88 may be provided at both the upbeam and downbeam ends of the electron-optical module 41. For example, the upbeam section of tube 88a may extend through an opening 74 at an upbeam end of the upbeam module 41a and the intermediate section 88b of tube may extend through an opening 74 at a downbeam end of the upbeam module 41a. In an embodiment the intermediate tube section 88b extends through an opening 74 at an upbeam end of the intermediate module 41b. The downbeam tube section 88c may extend through an opening 74 at the downbeam end of the intermediate module 41b.

As shown in Figure 16, an insulating cover 79 may be provided at an upbeam end of the electron-optical module 41. In an embodiment an insulating cover 79 may be provided at both the upbeam and downbeam ends of the electron-optical module 41. The insulating cover 79 may be provided around an opening in an electrostatic shield 71 of the shielding arrangement 80. The opening may be for insertion of an end of the tube 88 through the electrostatic shield 71.

As mentioned above, in an embodiment a tube 88 may be provided at the downbeam end of the electron-optical module 41. In an embodiment the tube 88 is at substantially the same potential as the most down beam electron-optical plate 60 of the stack. Alternatively, a potential difference may be applied between the tube 88 and the most down beam e electron-optical plate 60 of the stack so as to form an electrostatic field for operating on the electron beam. Such a potential difference may apply a focusing of the electron beam.

In an embodiment one or more of the sections of the shield arrangement 80 is connected to ground potential. For example, the shield arrangement 80 may be connected to the vacuum chamber 10 of the assessment apparatus 100.

In an embodiment the electron beam is a beam grid of a plurality of electron beams. That is in the earlier description reference to an electron beam such as shown in and described with reference to Figures 8 to 16 includes reference to a plurality of electron beams, for example as a beam grid such in an array of beams. The path of at least one of the beams of the beam grid may correspond to the path the electron beam described with reference to Figures 8 to 16, such as a beam towards the middle of the array, such as a central beam of the beam grid. The electron-optical plates of the stack 55 may comprise a series of electron-optical plates comprising a plurality of apertures for the paths of the plurality of electron beams of the beam grid.

In an embodiment a method of directing an electron beam is provided. The method is for directing the electron beam along a beam path towards a sample location.

In an embodiment the method comprises operating on the electron beam with one or more electron-optical plates 60 of a stack 55. In an embodiment the one or more electron-optical plates 60 are arranged across the beam path.

In an embodiment the method comprises using a shield arrangement 80. The shield arrangement 80 comprises an upbeam electrostatic shield 71 arranged across the beam path upbeam of the one or more electro-optical plates 60. The shield arrangement 80 comprises a downbeam electrostatic shield 72 arranged across the beam path downbeam of the one or more electron-optical plates 60. The shield arrangement 80 is used to deter electrical breakdown between the stack 55 and a component external to the stack 55. In an embodiment the shield arrangement 80 is used to confine an electrostatic field within the shield arrangement 80. Such an electrostatic field may, for example, be generated in operation of the one or more electron-optical plate on the electron beam along the beam path.

The electron-optical module 41 may comprise or be a lens assembly for operating on (or manipulating) electron beamlets. The lens assembly may, for example, be, or may be part of, an objective lens assembly or a condenser lens assembly. The lens assembly, such as an objective lens assembly, may further comprise an additional lens array comprising at least two plates such as a control lens array 250.

In an embodiment at least one of the electron-optical plates 60 comprises a micro-electro mechanical component. In an embodiment the electron-optical module 41 comprises one or more electron-optical elements which comprise an element which may be referred to as a microelectromechanical component (despite such component may not comprise a moving or moveable feature) or may be made using techniques suited to make microelectromechanical components (for example a `MEMS technique') some of which are designed to have electron-optical functionality. The electron-optical module 41, or at least components of the electron-optical module 41, may be manufactured by such techniques. The electron-optical module 41 may comprise one or more elements which may be considered MEMS elements. One or more of such elements may be controlled to be set at a high potential difference relative to a reference potential (e.g. ground) during use. Such elements may be electrically connected to one or more voltage supplies for supplying the voltages to the elements. In an embodiment a controller is configured to control the voltage applied to the elements. Such elements may require accurate positioning (for example alignment) within the electron-optical module 41 for example with respect to the path of the beam grid and with respect to other electron-optical elements within the device for example with respect to a source, with respect to a sample and/or the path of the beam grid. An embodiment of the invention is expected to allow for more accurate positioning (for example alignment) of such elements within the stack 55 of such an electron-optical module 41 such as during operation for example without distortion of the electron-optical module 41 for example by externally applied force or moment. An embodiment of the invention may in addition or alternatively enable more accurate positioning, for example alignment, of such elements with respect to other elements in the electron-optical device 40 and thus of the stack 55 of the electron-optical module comprising such elements within the electron-optical device 40.

As mentioned above, in an embodiment the electron-optical module 41 is an electron-optical lens assembly. The electron-optical lens assembly may comprise an objective lens assembly. The electron-optical lens assembly may be an objective lens assembly. In an alternative embodiment the electron-optical lens assembly is an electron-optical condenser lens assembly.

In an embodiment the electron-optical module 41 comprises a collimator. For example, in an embodiment the electron-optical module 41 comprises a magnetic collimator in combination with an electro static condenser lens arrays. The electron-optical module 41 may comprise a single aperture lens array with one or two macro electrodes, placed away from the virtual source conjugate plane.

In an alternative embodiment, the electron-optical module 41 comprises a magnetic macro lens in combination with an electrostatic slit deflector. The magnetic macro lens may be for collimating. As a further alternative, in an embodiment the electron-optical module 41 comprises a combined magnetic and electrostatic macro lens and a downbeam slit deflector.

In general, the electron-optical module 41 may comprise any plates such as a plate of a detector array, a plate of a lens electrode (into which multiple deflectors may be integrated) multiple deflector arrays, beam aperture arrays (e.g. an upper beam aperture array and/or a final beam limiting array), deflector arrays (e.g. strip deflector arrays) and other types of corrector elements.

The embodiments described within this document have focussed primarily on multi-beam electron-optical devices 40. The invention is equally applicable to single-beam electron-optical devices 40.

A plurality of electron-optical devices may be comprised in an electron-optical device array. The electron-optical devices of the electron-optical device array are preferably be configured to focus respective multi-beams simultaneously onto different regions of the same sample.

References to upper and lower, up and down, above and below, top and bottom etc. should be understood as referring to directions parallel to the (typically but not always vertical) upbeam (i.e. form an electron source) and downbeam (i.e. towards a sample) directions of charged particle beams impinging on the sample 208. Thus, references to upbeam and downbeam are intended to refer to directions in respect of the beam path independently of any present gravitational field. The references to beam path are to the intended position of a corresponding beam during operation of the charged particle apparatus. Within this context upbeam may be considered to relate to terms such as upper, up, above and top; and downbeam may be considered to relate to lower, down, below and bottom, for example. Such references when made in reference to an electron-optical element, such as an electrode plate, may be generally understood to relate, for a collimated beam path of a beam grid, to the optical axis of the beam and thus be orthogonal to the plane of the electron-optical element. In reference to an uncollimated beam, such as a divergent beam, the beam path may be considered to be relative to the axis of the mid-point of the beam, or the mid-point of beam grid when the beam is a plurality of beams such as in the beam grid. Therefore, although the orientation of the beam path may be considered an axis orthogonal to the plane of a planar electron-optical element, this may not always be the case; in some embodiments the beam path is angled (e.g., obliquely) relative to such a planar electron-optical element.

While the present invention has been described in connection with various embodiments, other embodiments of the invention will be apparent to those skilled in the art from consideration of the specification and practice of the invention disclosed herein. For example, as described above in an embodiment the substrate has portions of different thicknesses, with the electrical connector extending through the thinner portion. However, the thickness of the substrate may alternatively be uniform. The electrical connection for the electronic component may be further towards the periphery of the substrate than the electronic component and the electrically conductive layer may be electrically connected to the electrical connection. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims and clauses set out below.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses.

Clause 1. A charged particle-optical module for a charged particle-optical device configured to direct a charged particle beam along a beam path towards a sample location, the charged particle-optical module comprising: a stack comprising one or more charged particle-optical plates arranged across the beam path and configured to operate on the charged particle beam; and a shield arrangement comprising an upbeam electrostatic shield arranged across the beam path upbeam of the one or more charged particle-optical plates; and a downbeam electrostatic shield arranged across the beam path downbeam of the one or more charged particle-optical plates, wherein the shield arrangement is configured to deter electrical breakdown between the charged particle-optical module and a component external to the charged particle-optical module and/or to confine an electrostatic field within the charged particle-optical module, the electrostatic field for example generated in operation of the one or more charged particle-optical plates on the charged particle beam along the beam path.

Clause 2. The charged particle-optical module of clause 1, wherein the shield arrangement is configured to extend in a direction across the beam path beyond the one or more charged particle-optical plates, desirably the upbeam electrostatic shield and the downbeam electrostatic shield extend in a direction across the beam path beyond the one or more charged particle-optical plates.

Clause 3. The charged particle-optical module of clause 1 or 2, comprising at least one electrical connector for connecting at least one of the charged particle-optical plates to a voltage supply.

Clause 4. The charged particle-optical module of clause 3, wherein the shield arrangement extends in a direction across the beam path so as to deter electrical breakdown between the electrical connector and a component external to the charged particle-optical module.

Clause 5. A charged particle-optical module for a charged particle-optical device configured to direct a charged particle beam along a beam path towards a sample location, the charged particle-optical module comprising: a stack comprising one or more charged particle-optical plates arranged across the beam path and configured to operate on the charged particle beam; at least one electrical connector configured to connect at least one of the charged particle-optical plates to a voltage supply; and a shield arrangement configured to extend in a direction across the beam path upbeam of the stack and downbeam of the stack to protrude beyond the connectors, desirably so as to shield an external component to the module from electrical discharge with the at least one connector and/or the electrostatic fields generated within the module, desirably the shield arrangement comprising an upbeam electrostatic shield arranged across the beam path upbeam to extend in the direction across the beam path up beam of the stack and a downbeam electrostatic plate configured to extend in the direction across the beam path up beam of the stack.

Clause 6. The charged particle-optical module of any of clauses 3-5, wherein the electrical connector is located between the upbeam electrostatic shield and the downbeam electrostatic shield.

Clause 7. The charged particle-optical module of any preceding clause, wherein the upbeam electrostatic shield and the downbeam electrostatic shield are configured to have a common potential and/or are electrically connected to each other.

Clause 8. The charged particle-optical module of any preceding clause, wherein the shield arrangement comprises at least one side shield located to a side of the charged particle-optical plates in a direction in a plane across the beam path, wherein the side shield is configured to contribute to the confinement of electrostatic fields within the charged particle-optical module and/or to deter electrical breakdown between the charged particle-optical module and a component external to the charged particle-optical module for example to the side of the charged particle-optical module, desirably wherein the side shield is a side electrostatic shield.

Clause 9. The charged particle-optical module of clause 8, wherein the at least one side shield extends upbeam beyond the one or more charged particle-optical plates and/or downbeam beyond the one or more charged particle-optical plates.

Clause 10. The charged particle-optical module of clause 8 or 9, wherein the at least one side shield is electrically connected to the upbeam electrostatic shield and/or the downbeam electrostatic shield, desirably an individual side shield is connected to the upbeam and/or downbeam electrostatic shield, and/or one or more of the at least one side shield is configured to have the same potential as one or both of the upbeam electrostatic shield and/or the downbeam electrostatic shield.

Clause 11. The charged particle-optical module of any of clauses 8 to 10, wherein the at least one side shield comprises a conduit for a flow of thermal conditioning fluid for thermally conditioning the charged particle-optical module and/or one or more of the at least one side shield comprises a metal body, desirably the metal body comprising a respective conduit.

Clause 12. The charged particle-optical module of any preceding clause, comprising an insulator located at an inwardly facing surface of the shield arrangement for example, at least one of the upbeam electrostatic shield, the downbeam electrostatic shield and/or one more side shields desirably so as to deter electrical breakdown between the shield arrangement and another part of the charged particle-optical module.

Clause 13. The charged particle-optical module of clause 12, wherein, at least part of the shield arrangement comprises a conductive coating on an insulator, for example at least one of the downbeam electrostatic shield, the upbeam electrostatic shield and at least one of the side shields is comprised as a conductive coating on the insulator, desirably the insulator comprises a filling material such as potting material.

Clause 14. The charged particle-optical module of clause 12 or 13, wherein, a filling material such as potting material is provided between at least part of one more surfaces of the shield arrangement, such as at least one of the upbeam electrostatic shield, the downbeam electrostatic shield and at least one side shield, and the insulator so as to substantially avoid gaps between the electrostatic shield and the insulator.

Clause 15. The charged particle-optical module of any of clauses 12-14, wherein between at least part of one more surfaces of the shield arrangement and the stack is comprised a filling material such as potting material so as to substantially avoid gaps between the shield arrangement and the insulator.

Clause 16. The charged particle-optical module of any preceding clause, wherein in the shield arrangement is defined at least an opening, desirably wherein at least one of the upbeam electrostatic shield and the downbeam electrostatic shield comprises an opening for the beam path, desirably the opening being defined within a radially inward peripheral surface, desirably the opening is central in the charged particle-optical module, for example relative the stack.

Clause 17. The charged particle-optical module of clause 16, comprising an insulating cover configured to cover the radially inward peripheral surface of the electrostatic shield, for example the insulating cover is configured to define the limit of a coating on one or both of the upbeam electrostatic shield and the downbeam electrostatic shield, desirably the insulating cover is configured to cover an edge of a coating on a respective one of the upbeam electrostatic shield and the downbeam electrostatic shield, desirably so as to define the limit of the coating.

Clause 18. The charged particle-optical module of any preceding clause, wherein the shield arrangement comprises one or more of the charged particle-optical plates of the stack, desirably at least one of the upbeam electrostatic shield and the downbeam electrostatic shield comprises at least one of the charged particle-optical plates.

Clause 19. The charged particle-optical module of any preceding clause, wherein the stack comprises at least one spacer, desirably configured to support and/or electrically isolate at least one of the charged particle-optical plates, for example an individual spacer is located between a pair of the charged particle-optical plates, for example the shield arrangement comprising at least one spacer, desirably the spacer comprised in a respective one of the upbeam electrostatic shield and the downbeam electrostatic shield.

Clause 20. The charged particle-optical module of clause 19, wherein at least one of the spacers is a radial spacer arranged around one of the charged particle-optical plates, desirably such that the charged particle-optical plate is located between the beam path and the radial spacer, desirably the radial spacer configured to space the charged article-optical plate from another component of the charged particle-optical module in a direction along the beam path, the other component desirably is another charged particle-optical plate.

Clause 21. The charged particle-optical module of any preceding clause, at least one of the charged particle-optical plates comprising a detector arranged across the beam path, desirably the detector is configured to detect charged particles from the sample location, wherein the detector comprises a detector array desirably of detector elements.

Clause 22. The charged particle-optical module of any preceding clause, further comprising a tube portion configured to be around a portion of the beam path, desirably the tube portion is in contact with a charged particle-optical plate, desirably the tube portion is configured to protrude through an opening defined in the shield arrangement, for example the opening defined in one of the upbeam electrostatic shield and the downbeam electrostatic shield, desirably the tube positioned away from a surface of the opening.

Clause 23. The charged particle-optical module of any proceeding clause, wherein the charged particle beam is a beam grid of a plurality of charged particle beams and the charged particle-optical plates of the stack each comprise a plurality of apertures for the paths of the plurality of charged particle beams of the beam grid.

Clause 24. A charged particle-optical device configured to direct a charged particle beam along a beam path towards a sample location, the charged particle-optical device comprising the charged particle-optical module of any preceding clause.

Clause 25. A charged particle-optical device configured to direct a charged particle beam along a beam path towards a sample location, the charged particle-optical device comprising: a conductive tube configured to be around the beam path; and a charged particle-optical module that comprises: a stack comprising one or more charged particle-optical plates arranged across the beam path and configured to operate on the charged particle beam; and a shield arrangement configured to shield the stack and to extend in a direction across the beam path upbeam of the stack and in a direction across the beam path downbeam of the stack, the shield arrangement extending further away from the beam path than the conductive tube and the stack, desirably the module further comprising connectors for one more of the charged particle plates, the shield arrangement extending further away from the beam path than the connector, desirably further comprising another component configure to be set at a low potential desirably ground and configured to be adjacent a surface of the shielding arrangement such as the upbeam shield, desirably the other component having a surface corresponding to at least part of the upbeam shield for example the surface of the of the other component being parallel to and configured to face at least part of a surface of the upbeam shield.

Clause 26. The charged particle-optical device of clause 25, comprising at least one conductive tube around the beam path, wherein: the tube distanced is from the charged particle-optical module desirably at least the shield arrangement of the charged particle-optical module; the conductive tube is in electrical contact with a peripheral charged particle-optical plate of the stack, the tube desirably comprising at least a tube portion which is preferably in contact with a peripheral charge particle-optical plate of the stack; and/or at least a part of the tube is set to a potential, desirably the same as the peripheral charged particle-optical plate.

Clause 27. The charged particle-optical device of clause 26, wherein the tube extends through a beam opening defined in one of the upbeam electrostatic shield and the downbeam electrostatic shield, wherein the beam opening is desirably positioned in a shield towards a middle region of a dimension across the direction of the beam path, for example between opposite sides, for example equidistantly from two more sides, desirably the charged particle-optical device comprising an individual tube configured to extend through the upbeam electrostatic shield and the downbeam electrostatic shield respectively.

Clause 28. A charged particle-optical device of any of clauses 25-27, the charged particle-optical device comprising a removable module for removably placing within the device.

Clause 29. A charged particle-optical apparatus comprising the charged particle-optical module of any of clauses 1-24 or the charged particle-optical device of any of clauses 25-28.

Clause 30. The charged particle-optical apparatus of clause 29, comprising a voltage supply configured to supply an electrical potential to at least one of the charged particle-optical plates.

Clause 31. The charged particle-optical apparatus of clause 30, wherein the voltage supply is configured to supply the electrical potential such that a potential difference between at least one of the charged particle-optical plates and the shield arrangement is at least 1kV, optionally at least 2kV, optionally at least 5kV, optionally at least 10kV, optionally at least 20kV and optionally at least 30kV, optionally in the range of 1kV to 40 kV.

Clause 32. The charged particle-optical apparatus of any of clauses 29-31, comprising an actuatable stage for supporting a sample at the sample location.

Clause 33. A method of directing a charged particle beam along a beam path towards a sample location, the method comprising:
operating on the charged particle beam with one or more charged particle-optical plates of a stack, the one or more charged particle-optical plates arranged across the beam path; and
using a shield arrangement comprising an upbeam electrostatic shield arranged across the beam path upbeam of the one or more charged particle-optical plates and a downbeam electrostatic shield arranged across the beam path downbeam of the one or more charged particle-optical plates to deter electrical breakdown between the stack and a component external to the stack and/or to confine an electrostatic field within the shield arrangement, the electrostatic field for example generated in operation of the one or more charged particle-optical plates on the charged particle beam along the beam path.

## Claims

1. A charged particle-optical module for a charged particle-optical device configured to direct a charged particle beam along a beam path towards a sample location, the charged particle-optical module comprising:
a stack comprising one or more charged particle-optical plates arranged across the beam path and configured to operate on the charged particle beam; and
a shield arrangement comprising an upbeam electrostatic shield arranged across the beam path upbeam of the one or more charged particle-optical plates; and a downbeam electrostatic shield arranged across the beam path downbeam of the one or more charged particle-optical plates,
wherein the shield arrangement is configured to deter electrical breakdown between the charged particle-optical module and a component external to the charged particle-optical module and/or to confine an electrostatic field within the charged particle-optical module, the electrostatic field for example generated in operation of the one or more charged particle-optical plates on the charged particle beam along the beam path.

2. The charged particle-optical module of claim 1, wherein the shield arrangement is configured to extend in a direction across the beam path beyond the one or more charged particle-optical plates, desirably the upbeam electrostatic shield and the downbeam electrostatic shield extend in a direction across the beam path beyond the one or more charged particle-optical plates.

3. The charged particle-optical module of claim 1 or 2, comprising at least one electrical connector for connecting at least one of the charged particle-optical plates to a voltage supply.

4. The charged particle-optical module of claim 3, wherein the shield arrangement extends in a direction across the beam path so as to deter electrical breakdown between the electrical connector and a component external to the charged particle-optical module.

5. The charged particle-optical module of claims 3 or 4, wherein the electrical connector is located between the upbeam electrostatic shield and the downbeam electrostatic shield.

6. The charged particle-optical module of any preceding claim, wherein the upbeam electrostatic shield and the downbeam electrostatic shield are configured to have a common potential and/or are electrically connected to each other.

7. The charged particle-optical module of any preceding claim, wherein the shield arrangement comprises at least one side shield located to a side of the charged particle-optical plates in a direction in a plane across the beam path, wherein the side shield is configured to contribute to the confinement of electrostatic fields within the charged particle-optical module and/or to deter electrical breakdown between the charged particle-optical module and a component external to the charged particle-optical module for example to the side of the charged particle-optical module, desirably wherein the side shield is a side electrostatic shield.

8. The charged particle-optical module of claim 7, wherein the at least one side shield extends upbeam beyond the one or more charged particle-optical plates and/or downbeam beyond the one or more charged particle-optical plates.

9. The charged particle-optical module of claim 7 or 8, wherein the at least one side shield is electrically connected to the upbeam electrostatic shield and/or the downbeam electrostatic shield, desirably an individual side shield is connected to the upbeam and/or downbeam electrostatic shield, and/or one or more of the at least one side shield is configured to have the same potential as one or both of the upbeam electrostatic shield and/or the downbeam electrostatic shield.

10. The charged particle-optical module of any preceding claim, comprising an insulator located at an inwardly facing surface of the shield arrangement for example, at least one of the upbeam electrostatic shield, the downbeam electrostatic shield and/or one more side shields desirably so as to deter electrical breakdown between the shield arrangement and another part of the charged particle-optical module.

11. The charged particle-optical module of claim 10, wherein, at least part of the shield arrangement comprises a conductive coating on an insulator, for example at least one of the downbeam electrostatic shield, the upbeam electrostatic shield and at least one of the side shields is comprised as a conductive coating on the insulator, desirably the insulator comprises a filling material such as potting material.

12. The charged particle-optical module of any preceding claim, wherein in the shield arrangement is defined at least an opening, desirably wherein at least one of the upbeam electrostatic shield and the downbeam electrostatic shield comprises an opening for the beam path, desirably the opening being defined within a radially inward peripheral surface, desirably the opening is central in the charged particle-optical module, for example relative the stack.

13. The charged particle-optical module of any preceding claim, wherein the shield arrangement comprises one or more of the charged particle-optical plates of the stack, desirably at least one of the upbeam electrostatic shield and the downbeam electrostatic shield comprises at least one of the charged particle-optical plates.

14. The charged particle-optical module of any preceding claim, further comprising a tube portion configured to be around a portion of the beam path, desirably the tube portion is in contact with a charged particle-optical plate, desirably the tube portion is configured to protrude through an opening defined in the shield arrangement, for example the opening defined in one of the upbeam electrostatic shield and the downbeam electrostatic shield, desirably the tube positioned away from a surface of the opening.

15. The charged particle-optical module of any proceeding claim, wherein the charged particle beam is a beam grid of a plurality of charged particle beams and the charged particle-optical plates of the stack each comprise a plurality of apertures for the paths of the plurality of charged particle beams of the beam grid.
